# EUROPEAN PATENT SPECIFICATION

(11) **EP 4 208 945 B1**
(45) Date of publication and mention of the grant of the patent: **25.11.2026**
(21) Application number: 20781709.9
(22) Date of filing: 17.09.2020
(51) Int. Cl.: H03F 3/19, H03F 1/30, H03F 3/24

(54) **THERMAL COMPENSATION FOR RF POWER AMPLIFIER**
THERMISCHE KOMPENSATION FÜR EINEN RF VERSTÄRKER
COMPENSATION THERMIQUE POUR AMPLIFICATEUR DE PUISSANCE RF

(43) Date of publication of application: 12.07.2023
(73) Proprietor: Huawei Technologies Co., Ltd., Shenzhen, Guangdong 518129 (CN)
(72) Inventor: DENG, Jason Xiangdong, Plano, Texas 75024 (US)
(74) Representative: Epping - Hermann - Fischer
(86) International application number: PCT/US2020/051307
(87) International publication number: WO 2021/091620

(56) References cited:
- US-A1- 2002 097 097
- US-A1- 2009 027 130
- US-A1- 2009 212 863
- US-A1- 2011 193 628
- US-A1- 2013 034 144
- OZALAS MATTHEW T: "The Impact of Electro-Thermal Coupling on HBT Power Amplifiers", 2014 IEEE COMPOUND SEMICONDUCTOR INTEGRATED CIRCUIT SYMPOSIUM (CSICS), IEEE, 19 October 2014 (2014-10-19), pages 1 - 4, XP032706199, DOI: 10.1109/CSICS.2014.6978582

## Description

### FIELD

The disclosure generally relates to radio frequency (RF) power amplifiers.

### BACKGROUND

In a wireless terminal such as a cellular telephone, the RF power amplifier is one of the most critical components. The role of the RF power amplifier is to amplify a transmit power level for a modulated RF signal for transmission from an antenna. The RF power amplifier amplifies the modulated RF signal sufficiently to meet RF signal transmission power requirements for an expected application. The RF power amplifier also needs to have low RF signal distortion. In carrying out its role, the RF power amplifier consumes a substantial amount of power which can be problematic for wireless communication devices that operate on battery power. It is desirable, therefore, to reduce the power consumption of the RF power amplifier to extend battery life.

In some architectures, the RF power amplifier powers on and off in response to a transmit enable signal. For example, in WiFi communications, the RF amplifier may operate in a mode in which the RF amplifier powers on and off in response to a transmit enable signal. The temperature of the RF power amplifier rapidly increases when it powers on, and then rapidly cools back down when it is powered off. The gain of the RF power amplifier depends on temperature. Hence, the gain of the RF power amplifier can vary dramatically, at least for a brief time period as the ambient temperature of the RF power amplifier increases. The gain typically settles to a relatively stable gain after the ambient temperature of the RF power amplifier stabilizes. However, the RF power amplifier will typically transmit data as the ambient temperature increases. The unstable gain can lead to RF signal distortion. The RF signal distortion can result in loss of data at the receiver of the RF signal.

US 2009/027130 A1; relates to a power amplifier comprising a main power amplifier and a subsidiary power amplifier having an idle current smaller than idle current of the main power amplifier. The power amplifier is operated by switching the main power amplifier and the subsidiary power amplifier. Each of the main power amplifier and the subsidiary power amplifier comprises a former amplification element for amplifying RF signals, a latter amplification element for amplifying output signals from the former amplification element, a former bias circuit for driving the former amplification elements, and a latter bias circuit for driving the latter amplification elements, respectively. The spacing between the latter amplification element of the main power amplifier and the latter amplification element of the subsidiary power amplifier is not more than 100 µm. The spacing between the latter amplification element of the main power amplifier and the latter bias circuit of the subsidiary power amplifier is not less than 200 µm.

Document OZALAS MATTHEW T: "The Impact of Electro-Thermal Coupling on HBT Power Amplifiers", 2014 IEEE COMPOUND SEMICONDUCTOR INTEGRATED CIRCUIT SYMPOSIUM (CSICS), IEEE; describes the use of electro-thermal simulation to understand, predict, and account for cross-circuit thermal coupling in a commercial HBT power amplifier. Specifically, electro-thermal analysis is used to analyze how thermal coupling impacts gain compression and low frequency memory effects.

### BRIEF SUMMARY

According to one aspect of the present disclosure, there is provided an apparatus for amplifying a radio frequency (RF) signal. The apparatus comprises an RF amplifier configured to receive a temperature dependent bias input and the RF signal. The RF amplifier is configured to amplify the RF signal based on a transmit enable signal. The apparatus comprises one or more bias transistors configured to generate the temperature dependent bias signal. The apparatus comprises one or more heating transistors configured to heat the one or more bias transistors. The apparatus comprises a control circuit configured to cause the one or more heating transistors to heat the one or more bias transistors while the RF amplifier is powered on.

Optionally, in any of the preceding aspects, the control circuit is configured to generate a DC bias current that tracks the transmit enable signal. The circuit is configured to provide the DC bias current to the one or more heating transistors to cause the one or more heating transistors to heat the one or more bias transistors while the RF amplifier is powered on.

Optionally, in any of the preceding aspects, the control circuit is configured to provide heating for the one or more bias transistors based on a received control signal that is generated by a processor based upon a specified parameter. The parameter specifies an amount of heating compensation for the one or more bias transistors. The control circuit is configured to generate the DC bias current based on the control signal. A magnitude of the DC bias current controls an amount of heat generated by the heating transistors to heat the one or more bias transistors while the RF amplifier is powered on.

Optionally, in any of the preceding aspects, the control circuit is configured to determine a magnitude of the DC bias current based on a target power of the amplified RF signal output by the RF amplifier.

Optionally, in any of the preceding aspects, the control circuit is configured to sample the amplified RF signal from the RF amplifier and provide the sampled amplified RF signal to the one or more heating transistors. The one or more heating transistors are configured to heat the one or more bias transistors based on a magnitude of the amplified RF signal while the RF amplifier is powered on.

Optionally, in any of the preceding aspects, the one or more heating transistors comprise one or more bipolar junction transistors. The control circuit provides the DC bias current to a base of each of the one or more bipolar junction transistors. The control circuit provides the amplified RF signal to the base of each of the one or more bipolar junction transistors.

Optionally, in any of the preceding aspects, the one or more heating transistors comprise a first transistor on a first side of the one or more bias transistors and a second transistor on a second side of the one or more bias transistors. The second side is opposite the first side.

Optionally, in any of the preceding aspects, the RF amplifier comprises a pre-amplification stage having a first RF input, the bias input which is a first bias input, and a first RF output. The RF amplifier comprises a power amplification stage having a second RF input coupled to the first RF output, a second bias input and a second RF output. The one or more bias transistors is configured to provide a first bias signal to the first bias input of the pre-amplification stage and to provide a second bias signal to the second bias input of the power amplification stage. The control circuit is configured to sample the amplified RF signal at the first RF output. The one or more heating transistors is configured to heat the one or more bias transistors based on a magnitude of the amplified RF signal at the first RF output.

Optionally, in any of the preceding aspects, the RF amplifier comprises a pre-amplification stage having a first RF input, a first bias input, and a first RF output. The RF amplifier comprises a power amplification stage having a second RF input coupled to the first RF output, a second bias input and a second RF output. The one or more bias transistors is configured to provide a first bias signal to the first bias input of the pre-amplification stage and to provide a second bias signal to the second bias input of the power amplification stage. The control circuit is configured to sample the amplified RF signal at the second RF output. The one or more heating transistors is configured to heat the one or more bias transistors based on a magnitude of the amplified RF signal at the second RF output.

Optionally, in any of the preceding aspects, the one or more bias transistors comprise a first set of one or more bias transistors configured to provide the first bias signal to the pre-amplification stage and a second set of one or more bias transistors configured to provide the second bias signal to the power amplification stage. The one or more heating transistors comprise a first heating transistor between the first set of one or more bias transistors and the second set of one or more bias transistors.

Optionally, in any of the preceding aspects, the one or more heating transistors further comprises a second heating transistor on a first side of the first set of one or more bias transistors that is opposite a second side of the first set of one or more bias transistors that is adjacent to the first heating transistor. The one or more heating transistors further comprises a third heating transistor on a first side of the second set of one or more bias transistors that is opposite a second side of the second set of one or more bias transistors that is adjacent to the first heating transistor.

A further aspect comprises a method for amplifying a radio frequency (RF) signal. The method comprises operating an RF amplifier in a mode in which the RF amplifier powers on and off in response to a transmit enable signal. The method comprises amplifying the RF signal, by the RF amplifier, when the RF amplifier is powered on. The method comprises providing a temperature dependent bias signal from one or more bias transistors to a bias input of the RF amplifier when the RF amplifier is powered on. The method comprises heating the one or more bias transistors, by one or more heating transistors, while the RF amplifier is powered on.

According to still one other aspect of the present disclosure, there is provided a radio frequency (RF) signal transmitter for transmitting an RF signal. The RF transmitter comprises a pre-amplification stage having an RF input, an RF output, and a first bias input. The pre-amplification stage configured to receive the RF signal at the RF input of the pre-amplification stage and to provide a pre-amplified RF signal to the RF output of the pre-amplification stage. The RF transmitter comprises a power amplification stage having an RF input coupled to the RF output of the pre-amplification stage, an RF output, and a second bias input. The power amplification stage is configured to receive the pre-amplified RF signal at the RF input of the power amplification stage and to provide a power amplified RF signal to the RF output of the power amplification stage. The pre-amplification stage and the power amplification stage are configured to amplify the RF signal based on a transmit enable signal. The RF transmitter comprises an antenna coupled to the RF output of the power amplification stage. The antenna is configured to transmit the power amplified RF signal. The RF transmitter comprises one or more bias transistors configured to provide a first bias signal to the first bias input and a second bias signal to the second bias input. The RF transmitter comprises one or more heating transistors configured to heat the one or more bias transistors. The RF transmitter comprises a control circuit configured to cause the one or more heating transistors to heat the one or more bias transistors while the pre-amplification stage and the power amplification stage are powered on.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter. The claimed subject matter is not limited to implementations that solve any or all disadvantages noted in the Background.

### BRIEF DESCRIPTION OF THE DRAWINGS

Aspects of the present disclosure are illustrated by way of example and are not limited by the accompanying figures for which like references indicate elements.
FIG. 1 illustrates a wireless network for communicating data.
FIG. 2 illustrates example details of user equipment (UE) that may implement the methods and teachings according to this disclosure.
FIG. 3 illustrates an example base station that may implement the methods and teachings according to this disclosure.
FIG. 4 illustrates a block diagram of one embodiment of a direct conversion receiver (DCR).
FIG. 5 illustrates details of one example of a direct conversion transmitter.
FIG. 6 depicts one embodiment of an apparatus configured to amplify an RF signal.
FIGs. 7A and 7B depict embodiments of an apparatus configured to amplify an RF signal.
FIG. 8 depicts an example of a transmit enable signal (TX_EN).
FIG. 9 depicts an example of a thermal compensation signal.
FIG. 10 depicts current versus time for a DC bias current that tracks a transmit enable signal.
FIG. 11 is a circuit schematic of one embodiment of a circuit for amplifying an RF signal.
FIG. 12 depicts one embodiment of a flowchart of a process of amplifying an RF signal.
FIG. 13 depicts one embodiment of a flowchart of a process of biasing heating transistors.
FIG. 14 depicts a flowchart of one embodiment of a process of providing an amplifier RF signal to heating transistors.
FIG. 15 is a graph that depicts ambient temperature for the amplifier and the bias circuitry if no thermal compensation were to be used.
FIG. 16 is a graph that depicts gain of an RF amplifier versus time, if no thermal compensation were to be used.
FIG. 17 is a graph that depicts ambient temperature for the amplifier and the bias circuitry if various levels of thermal compensation were to be used.
FIG. 18 is a graph that depicts gain of an RF amplifier versus time, if various levels of thermal compensation were to be used

### DETAILED DESCRIPTION

The present disclosure will now be described with reference to the figures, which in general relate to thermal compensation in RF power amplifiers. In an embodiment, the RF amplifier is configured to operate in a mode in which the RF amplifier is powered on and off in response to a transmit enable signal. One or more bias transistors are configured to provide a bias signal to a bias input of the RF amplifier. The one or more bias transistors may also be powered on and off when the RF amplifier is powered on and off. The temperature of the RF amplifier may increase rapidly when it is powered on and cool rapidly when RF amplifier is powered off. Without thermal compensation, the one or more bias transistors may heat up much more slowly when the RF amplifier when both are powered on. This could potentially result in unstable gain in the RF amplifier, as well as RF signal distortion. In an embodiment, thermal compensation results in a constant and stable gain in the RF power amplifier. Hence, RF signal distortion is reduced or eliminated. Therefore, data loss in the received RF signal is reduced or eliminated.

In an embodiment, thermal compensation is provided by one or more heating transistors that are configured to heat the one or more bias transistors while the RF amplifier is powered on. In one embodiment, a control circuit is configured to generate a DC bias current that tracks the transmit enable signal. The control circuit provides the DC bias current to the one or more heating transistors to cause the one or more heating transistors to heat the one or more bias transistors while the RF amplifier is powered on. In one embodiment, the control circuit is configured to sample an amplified RF signal from the RF amplifier and provide the sampled amplified RF signal to the one or more heating transistors. Thus, the one or more heating transistors are configured to heat the one or more bias transistors through thermodynamic coupling based on a magnitude of the amplified RF signal while the RF amplifier is powered on. Hence, the heating transistors provide heat to allow the bias transistors to increase in temperature proportionately to the RF power amplifier to reduce thermal mismatch and to stabilize the gain response of the RF amplifier. Thus, RF signal distortion is reduced or eliminated. Therefore, data loss in the received RF signal is reduced or eliminated.

It is understood that the present embodiments of the disclosure may be implemented in many different forms and that claim's scopes should not be construed as being limited to the embodiments set forth herein. Rather, these embodiments are provided so that this disclosure will be thorough and complete and will fully convey the inventive embodiment concepts to those skilled in the art. Indeed, the disclosure is intended to cover alternatives, modifications and equivalents of these embodiments, which are included within the scope and spirit of the disclosure as defined by the appended claims. Furthermore, in the following detailed description of the present embodiments of the disclosure, numerous specific details are set forth in order to provide a thorough understanding. However, it will be clear to those of ordinary skill in the art that the present embodiments of the disclosure may be practiced without such specific details.

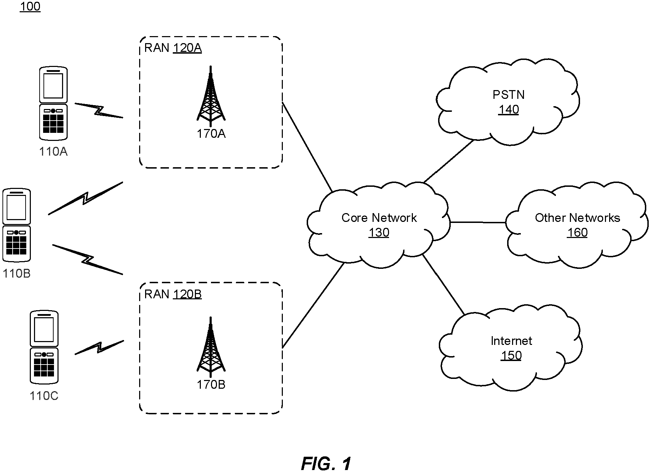

FIG. 1 illustrates a wireless network for communicating data. The communication system 100 includes, for example, user equipment 110A, 110B, and 110C, radio access networks (RANs) 120A and 120B, a core network 130, a public switched telephone network (PSTN) 140, the Internet 150, and other networks 160. Additional or alternative networks include private and public data-packet networks including corporate intranets. While certain numbers of these components or elements are shown in the figure, any number of these components or elements may be included in the system 100.

In one embodiment, the wireless network may be a fifth generation (5G) network including at least one 5G base station which employs orthogonal frequency-division multiplexing (OFDM) and/or non-OFDM and a transmission time interval (TTI) shorter than 1 milliseconds (e.g. 100 or 200 microseconds), to communicate with the communication devices. In general, a base station may also be used to refer to any of the eNB and the 5G BS (gNB). In addition, the network may further include a network server for processing information received from the communication devices via the at least one eNB or gNB.

System 100 enables multiple wireless users to transmit and receive data and other content. The system 100 may implement one or more channel access methods, such as but not limited to code division multiple access (CDMA), time division multiple access (TDMA), frequency division multiple access (FDMA), orthogonal FDMA (OFDMA), or single-carrier FDMA (SC-FDMA).

The user equipment (UE) 110A, 110B, and 110C, which can be referred to individually as a UE 110, or collectively as the UEs 110, are configured to operate and/or communicate in the system 100. For example, a UE 110 can be configured to transmit and/or receive wireless signals or wired signals. Each UE 110 represents any suitable end user device and may include such devices (or may be referred to) as a user equipment/device, wireless transmit/receive unit (UE), mobile station, fixed or mobile subscriber unit, pager, cellular telephone, personal digital assistant (PDA), smartphone, laptop, computer, touchpad, wireless sensor, wearable devices or consumer electronics device. In some embodiments, the UEs 110 communicate with the RANs 120 using an IEEE 802.11 standard.

In the depicted embodiment, the RANs 120A, 120B include one or more base stations (BSs) 170A, 170B, respectively. The RANs 120A and 120B can be referred to individually as a RAN 120, or collectively as the RANs 120. Similarly, the base stations (BSs) 170A and 170B can be referred individually as a base station (BS) 170, or collectively as the base stations (BSs) 170. Each of the BSs 170 is configured to wirelessly interface with one or more of the UEs 110 to enable access to the core network 130, the PSTN 140, the Internet 150, and/or the other networks 160. For example, the base stations (BSs) 170 may include one or more of several well-known devices, such as a base transceiver station (BTS), a Node-B (NodeB), an evolved NodeB (eNB), a next (fifth) generation (5G) NodeB (gNB), a Home NodeB, a Home eNodeB, a site controller, an access point (AP), or a wireless router, or a server, router, switch, or other processing entity with a wired or wireless network.

In one embodiment, the BS 170A forms part of the RAN 120A, which may include one or more other BSs 170, elements, and/or devices. Similarly, the BS 170B forms part of the RAN 120B, which may include one or more other BSs 170, elements, and/or devices. Each of the BSs 170 operates to transmit and/or receive wireless signals within a particular geographic region or area, sometimes referred to as a "cell." In some embodiments, multiple-input multiple-output (MIMO) technology may be employed having multiple transceivers for each cell.

The BSs 170 communicate with one or more of the UEs 110 over one or more air interfaces (not shown) using wireless communication links. The air interfaces may utilize any suitable radio access technology.

It is contemplated that the system 100 may use multiple channel access functionality, including for example schemes in which the BSs 170 and UEs 110 are configured to implement the Long Term Evolution wireless communication standard (LTE), LTE Advanced (LTE-A), and/or LTE Multimedia Broadcast Multicast Service (MBMS). In other embodiments, the base stations 170 and user equipment 110A-110C are configured to implement UMTS, HSPA, or HSPA+ standards and protocols. Of course, other multiple access schemes and wireless protocols may be utilized.

The RANs 120 are in communication with the core network 130 to provide the UEs 110 with voice, data, application, Voice over Internet Protocol (VoIP), or other services. As appreciated, the RANs 120 and/or the core network 130 may be in direct or indirect communication with one or more other RANs (not shown). The core network 130 may also serve as a gateway access for other networks (such as PSTN 140, Internet 150, and other networks 160). In addition, some or all of the UEs 110 may include functionality for communicating with different wireless networks over different wireless links using different wireless technologies and/or protocols.

The RANs 120 may also include millimeter and/or microwave access points (APs). The APs may be part of the BSs 170 or may be located remote from the BSs 170. The APs may include, but are not limited to, a connection point (e.g., a Millimeter Wave (mmW) connection point) or a BS 170 capable of mmW communication (e.g., a mmW base station). The mmWAPs may transmit and receive signals in a frequency range, for example, from 24 GHz to 100 GHz, but are not required to operate throughout this range. The RANs 120 may also transmit and receive signals in a frequency range, for example, from 900 MHz to 6 GHz. As used herein, the term base station is used to refer to a base station and/or a wireless access point.

The RANs 120 may communicate with the UEs 110 using time division multiplexing (TDD) in which the same frequency band is used for both uplink and downlink. When using division multiplexing (TDD) there is not a continuous radio linkage between a RAN 120 and a UE 110. Instead, the system constantly switches between the UE 110 being in a transmit mode (while the RAN 120 is in a receive mode) and the UE 110 being in a receive mode (while the RAN 120 is in a transit mode). In such a mode, a transmitter in the UE 110 may repeatedly switch on and off.

Although FIG. 1 illustrates one example of a communication system, various changes may be made to FIG. 1. For example, the communication system 100 could include any number of user equipment, base stations, networks, or other components in any suitable configuration. It is also appreciated that the term user equipment may refer to any type of wireless device communicating with a radio network node in a cellular or mobile communication system. Non-limiting examples of user equipment are a target device, device-to-device (D2D) user equipment, machine type user equipment or user equipment capable of machine-to-machine (M2M) communication, laptops, PDA, iPad, Tablet, mobile terminals, smart phones, laptop embedded equipped (LEE), laptop mounted equipment (LME) and USB dongles.

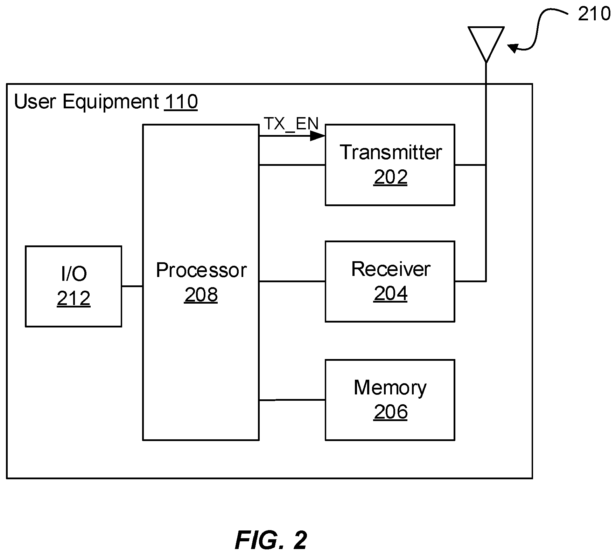

FIG. 2 illustrates example details of a UE 110 that may implement the methods and teachings according to this disclosure. The UE 110 may for example be a mobile telephone, but may be other devices in further examples such as a desktop computer, laptop computer, tablet, hand-held computing device, automobile computing device and/or other computing devices. As shown in the figure, the exemplary UE 110 is shown as including at least one transmitter 202, at least one receiver 204, memory 206, at least one processor 208, and at least one input/output device 212. The processor 208 can implement various processing operations of the UE 110. For example, the processor 208 can perform signal coding, data processing, power control, input/output processing, or any other functionality enabling the UE 110 to operate in the system 100 (FIG. 1). The processor 208 may include any suitable processing or computing device configured to perform one or more operations. For example, the processor 208 may include a microprocessor, microcontroller, digital signal processor, field programmable gate array, or application specific integrated circuit.

The transmitter 202 can be configured to modulate data or other content for transmission by at least one antenna 210. The transmitter 202 can also be configured to amplify, filter and a frequency convert RF signals before such signals are provided to the antenna 210 for transmission. The transmitter 202 can include any suitable structure for generating signals for wireless transmission.

The receiver 204 can be configured to demodulate data or other content received by the at least one antenna 210. The receiver 204 can also be configured to amplify, filter and frequency convert RF signals received via the antenna 210. The receiver 204 is an RF signal receiver, in some embodiments. The receiver 204 can include any suitable structure for processing signals received wirelessly. The antenna 210 can include any suitable structure for transmitting and/or receiving wireless signals. The same antenna 210 can be used for both transmitting and receiving RF signals, or alternatively, different antennas 210 can be used for transmitting signals and receiving signals.

In some embodiments, the UE 110 is configured to operate the transmitter 202 in a pulse mode. In an embodiment, the processor 208 issues a transmit enable signal (TX_EN) to the transmitter 202 to cause the transmitter 202 to operate in the pulse mode. In an embodiment of the pulse mode, the transmitter 202 is switched between and active (powered on and transmitting state) and an inactive (powered off) state. Powering the transmitter 202 off while not transmitting saves considerable power. However, the transmitter 202 may undergo considerable temperature change as a consequence. These temperature changes can potentially increase distortion in the transmitted RF signal. Embodiments of a UE 110 have thermal compensation to reduce or eliminate such signal distortion.

It is appreciated that one or multiple transmitters 202 could be used in the UE 110, one or multiple receivers 204 could be used in the UE 110, and one or multiple antennas 210 could be used in the UE 110. Although shown as separate blocks or components, at least one transmitter 202 and at least one receiver 204 could be combined into a transceiver. Accordingly, rather than showing a separate block for the transmitter 202 and a separate block for the receiver 204 in FIG. 2, a single block for a transceiver could have been shown. The UE 110 further includes one or more input/output devices 212. The input/output devices 212 facilitate interaction with a user. Each input/output device 212 includes any suitable structure for providing information to or receiving information from a user, such as a speaker, microphone, keypad, keyboard, display, or touch screen.

In addition, the UE 110 includes at least one memory 206. The memory 206 stores instructions and data used, generated, or collected by the UE 110. For example, the memory 206 could store software or firmware instructions executed by the processor(s) 208 and data used to reduce or eliminate interference in incoming signals. In an embodiment, memory 206 stores software or firmware instructions executed by the processor(s) 208 and data used to provide thermal compensation for an RF power amplifier, as described herein. In an embodiment, the memory 206 stores one or more parameters that specify a magnitude of a thermal compensation signal. In an embodiment, the memory 206 stores a table that specifies different magnitudes for the thermal compensation signal based on a target power of an RF signal that is output from the RF power amplifier. The target power output may be determined by factors such as a signal strength and/or quality of an RF signal that is received from a device to which the UE 110 is transmitting. The thermal compensation signal may be used to control a magnitude of a DC bias current that is provided to heating transistors, as described herein. Thus, the magnitude of the DC bias current may depend on a target power of the RF signal that is amplified by the RF amplifier. Each memory 206 includes any suitable volatile and/or non-volatile storage and retrieval device(s). Any suitable type of memory may be used, such as random access memory (RAM), read only memory (ROM), hard disk, optical disc, subscriber identity module (SIM) card, memory stick, secure digital (SD) memory card, and the like.

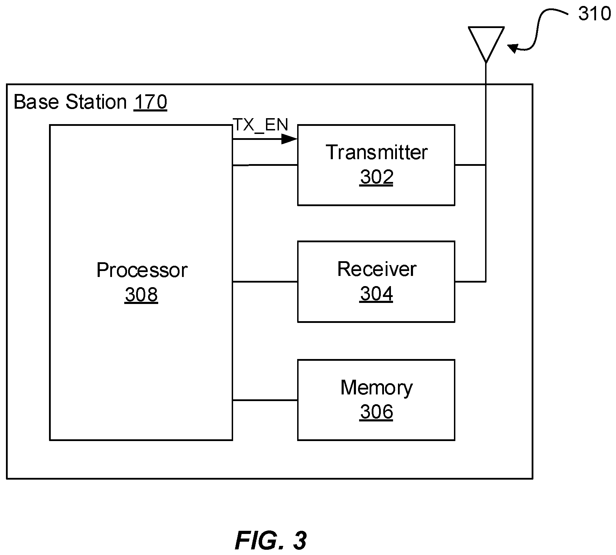

FIG. 3 illustrates an example BS 170 that may implement the methods and teachings according to this disclosure. As shown in the figure, the BS 170 includes at least one processor 308, at least one transmitter 302, at least one receiver 304, one or more antennas 310, and at least one memory 306. The processor 308 implements various processing operations of the BS 170, such as signal coding, data processing, power control, input/output processing, or any other functionality. Each processor 308 includes any suitable processing or computing device configured to perform one or more operations. Each processor 308 could, for example, include a microprocessor, microcontroller, digital signal processor, field programmable gate array, or application specific integrated circuit.

Each transmitter 302 includes any suitable structure for generating signals for wireless transmission to one or more UEs 110 or other devices. Each receiver 304 includes any suitable structure for processing signals received wirelessly from one or more UEs 110 or other devices. Although shown as separate blocks or components, at least one transmitter 302 and at least one receiver 304 could be combined into a transceiver. Each antenna 310 includes any suitable structure for transmitting and/or receiving wireless signals. While a common antenna 310 is shown here as being coupled to both the transmitter 302 and the receiver 304, one or more antennas 310 could be coupled to the transmitter(s) 302, and one or more separate antennas 310 could be coupled to the receiver(s) 304. Each memory 306 includes any suitable volatile and/or non-volatile storage and retrieval device(s).

In some embodiments, the base station 170 is configured to operate the transmitter 302 in a pulse mode. In an embodiment, the processor 308 issues a transmit enable signal (TX_EN) to the transmitter 302 to cause the transmitter 302 to operate in the pulse mode. In an embodiment of the pulse mode, the transmitter 302 is switched between and active (transmitting state) and an inactive (off) state. Powering the transmitter 302 off while not transmitting saves considerable power. However, the transmitter 302 may undergo considerable temperature change as a consequence. These temperature changes can potentially increase distortion in the transmitted RF signal. Embodiments of a base station 170 have thermal compensation to reduce or eliminate such signal distortion. In an embodiment, memory 306 stores software or firmware instructions executed by the processor(s) 308 and data used to provide thermal compensation for an RF power amplifier, as described herein. In an embodiment, the memory 306 stores one or more parameters that specify a magnitude of a thermal compensation signal. The thermal compensation signal may be used to control a magnitude of a DC bias current that is provided to heating transistors, as described herein.

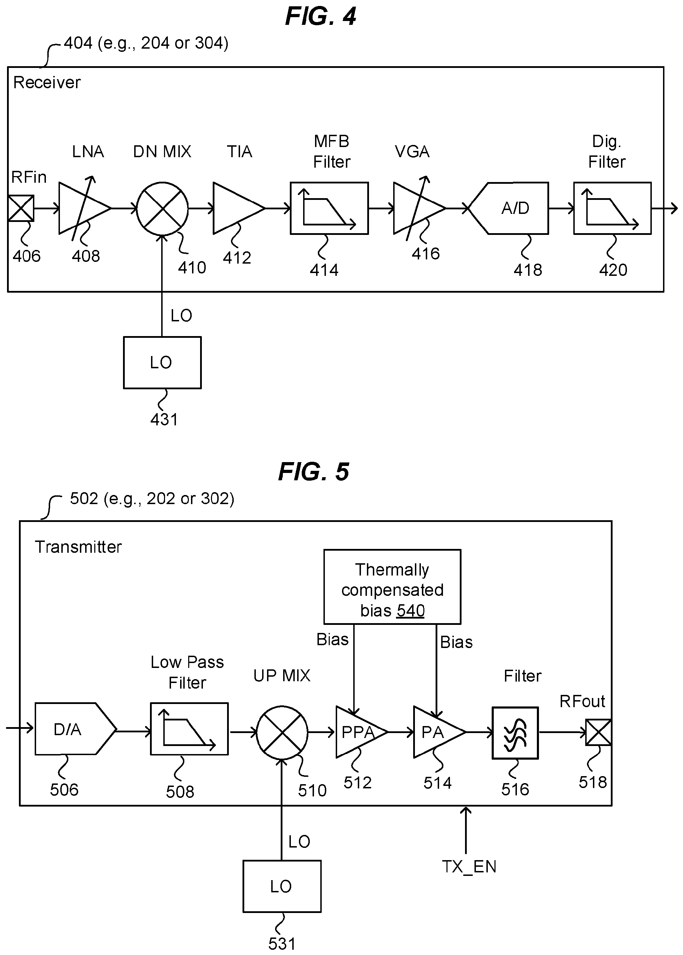

FIG. 4 illustrates a block diagram of one embodiment of a direct conversion receiver (DCR) 404, which can be the receiver 204 included in the UE 110 (shown in FIG. 2) or the receiver 304 included in the BS 170 (shown in FIG. 3), but is not limited thereto. The DCR 404 may also be referred to as a homodyne receiver or a zero-IF (Intermediate Frequency) receiver. The DCR 404 demodulates an incoming radio frequency (RF) signal using synchronous detection driven by a local oscillator (LO) 431. The frequency of the local oscillator 431 may be very close to or equal to the carrier frequency of the desired signal. The DCR 404 may also be referred to as an RF signal receiver.

Referring to FIG. 4, the receiver 404 is shown as including an input 406 at which is received as a radio frequency (RF) signal, and thus, the input 406 can also be referred to as the RF input 406. The RF input 406 can be coupled to an antenna or a coupler, but is not limited thereto. The RF signal received by the RF input 406 is provided to a low noise amplifier (LNA) 408, which may have an adjustable gain. The LNA 408 amplifies the relatively low-power RF signal it receives without significantly degrading the signal's signal-to-noise ratio (SNR).

The amplified RF signal that is output by the LNA 408 is provided to a frequency mixer 410. The frequency mixer 410 may input signals at two frequencies *f*₁, *f*₂, and mix them to create two new signals, one at the sum *f*₁ + *f*₂, and the other at the difference *f*₁ - *f*₂. Typically, only one of these new signals is used. The frequency mixer 410 receives the amplifier RF signal from the LNA 408, and an oscillator signal (LO) from a local oscillator, as the two input signals. Thus, the frequency mixer 410 may create a new signal from the amplifier RF signal and the oscillator signal. The frequency mixer 410 may shift (e.g., decrease) a frequency of the amplifier RF signal by a frequency of the oscillator signal to create the new signal. The amplifier RF signal may occupy a frequency range, in which case the frequency mixer 410 may shift the frequency range of the amplifier RF signal by a frequency of the oscillator signal. The frequency mixer 410 in FIG. 4 is a down-mixer (DN MIX) that frequency down-converts the amplified RF signal from a relatively high frequency to a baseband frequency, in one embodiment.

Still referring to FIG. 4, the frequency down-converted signal that is output from the mixer 410 is shown as being provided to a trans-impedance amplifier (TIA) 412. The TIA 412 acts as a current buffer to isolate a multi-feedback (MFB) filter 414 that is downstream of the TIA 412, from the mixer 410 that is upstream of the TIA 412. The MBF filter 414 low pass filters the frequency down-converted signal, to filter out high frequency signal components that are not of interest, such as HF noise. The filtered signal that is output from the MBF filter 414 is provided to a variable gain amplifier (VGA) 416, which is used to amplify the filtered signal before it provided to an analog-to-digital converter (A/D) 418, which converts the signal from an analog signal to a digital signal. The digital signal output from the A/D 418 is then provided to a digital filter 420, which performs additional filtering to remove out of band signal components and attenuates quantization energy from the A/D 418. The filtered digital signal that is output by the digital filter 420 is then provided to further digital circuitry that is downstream from the digital filter 420. Such further digital circuity can include, for example, a digital signal processor (DSP), but is not limited thereto. The same DSP, or a different DSP, can be used to implement the digital filter 420.

The local oscillator 431 may include a voltage-controlled oscillator (VCO), a digital controlled oscillator (DCO), or other circuit that provides the LO signal. In one embodiment, the local oscillator 431 includes a phase-locked loop (PLL), which contains a VCO. The LO signal is provided to the mixer 410 for use in the down-conversion process. Although shown as outside of receiver 404, depending on the embodiment, the local oscillator 431 can be formed on the same integrated circuit as one or more of the other elements in FIG. 4.

The receiver 204 in the UE 110 (shown in FIG. 2), as well as the receiver 304 included in the BS 170, are not limited to being direct conversion receivers. For example, receivers 204, 304 could be superheterodyne receivers that have a frequency mixer that changes the incoming radio signal to an intermediate frequency. After processing the intermediate frequency signal, the superheterodyne receiver may have a frequency mixer that down-converts the processed intermediate frequency signal to a baseband signal.

FIG. 5 illustrates details of one example of a direct conversion transmitter 502, which can be the transmitter 202 included in the UE 110 (shown in FIG. 2) or the transmitter 302 included in the BS 170 (shown in FIG. 3), but is not limited thereto. The direct conversion transmitter 502 may also be referred to as a direct modulation transmitter. Referring to FIG. 5, the transmitter 502 is shown as including an output 518 at which is provided as a radio frequency (RF) signal, and thus, the output 518 can also be referred to as the RF output 518. The RF output 518 can be coupled to an antenna or a coupler, but is not limited thereto. The RF signal provided by the RF output 518 is provided from a power amplifier PA 514 though the bandpass or notch filter 516. The filter 516 can, for example, be a duplex/SAW filter and is used to remove unwanted frequency components above and below the desired RF frequency range from the amplified RF output signal generated by PA 514. The power amp PA 514 receives its input from a power pre-amplifier PPA 512, which initially receives the up-converted signal to be transmitted from the mixer 510. PPA 512 may be referred to as a pre-amplification stage. PA 514 may be referred to as a power amplification stage. Still referring to FIG. 5 the signal to be transmitted is received from the processor 208 of UE 110 of FIG. 2 or processor 308 of BS 170 of FIG. 3 at the digital to analog converter 506, with the digitized signal being filtered by low pass filter 508 to initially remove any high frequency noise before being up-converted at the frequency mixer 510.

Frequency mixer 510 may input signals at two frequencies *f*₁, *f*₂, and mix them to create two new signals, one at the sum *f*₁ + *f*₂, and the other at the difference *f*₁- *f*₂. Typically, only one of these new signals is used. The analog version of the signal ("analog signal") is provided to frequency mixer 510, as one input signal. Frequency mixer 510 also receives oscillator signal LO from a local oscillator, as the other input signal. Thus, the frequency mixer 510 may create a new signal from the analog signal and the oscillator signal. The frequency mixer 510 may shift (e.g., increase) a frequency of the analog signal by a frequency of the oscillator signal to create the new signal. In one embodiment, the analog signal is a baseband signal. The oscillator signal is used as a carrier wave, in one embodiment. In one embodiment, the frequency mixer 510 modulates the oscillator signal (e.g., carrier wave) with the baseband signal to generate a radio frequency signal.

The analog signal may occupy a frequency range, in which case the frequency mixer 510 may shift the frequency range of the analog signal by a frequency of the oscillator signal. The frequency mixer 510 in FIG. 5 is an up-mixer (UP MIX) that frequency up-converts the analog signal. In one embodiment, the frequency mixer 510 is an up-mixer (UP MIX) that frequency up-converts the analog signal to an RF signal. The local oscillator signal LO in FIG. 5 can be provided by a local oscillator 531. The local oscillator 531 may contain a VCO, DCO, or other circuit that provides the LO signal. The local oscillator 531 includes a PLL that contains a VCO, in one embodiment. The LO signal is provided to the frequency mixer 510 for use in the up-conversion process. Although shown as outside of transmitter 502, depending on the embodiment, the local oscillator 531 can be formed on the same integrated circuit as one or more of the other elements in FIG. 5.

The transmitter 202 in the UE 110 (shown in FIG. 2), as well as the transmitter 302 included in the BS 170, are not limited to being direct conversion transmitters. For example, receivers 204, 304 could be superheterodyne transmitters that have a frequency mixer that shifts the analog signal to an intermediate frequency signal. The frequency mixer modulates an oscillator signal with the analog signal to generate the intermediate frequency signal, in one embodiment. After processing the intermediate frequency signal, the superheterodyne transmitter may have a frequency mixer that up-converts the processed intermediate frequency signal to a radio frequency signal.

In some embodiments, the transmitter 502 is operated in a pulse mode. In an embodiment of the pulse mode, the transmitter 502 powers on and off in response to a transmit enable signal (e.g., TX_EN). The transmit enable signal may be provided by the processor (e.g., 208, 308). In some embodiments, the pulse mode is used to transmit Wi-Fi signals. Considerable power is saved by powering off the transmitter 502 when the transmitter is not being used to transmit a signal. However, at least some of the components in the transmitter 502 may undergo significant temperature changes due to this on/off cycling. The power pre-amplifier PPA 512 and/or the power amplifier PA 514 may heat up quite quickly when the transmitter 502 is enabled due to the high power consumption of those components. For example, the ambient temperature of the PPA 512 and/or the PA 514 may increase by about 150 degrees Celsius in a few microseconds. However, other components in the transmitter 502 could potentially heat up more slowly. For example, if thermal compensation were not used, then components that provide a bias current to the PPA 512 and/or the PA 514 may heat up much more slowly than the PPA 512 and/or the PA 514. These differences in temperature profiles can lead to instability in the gain of the PPA 512 and/or the PA 514. Thus, the differences in temperature profiles can lead to distortion in the transmitted RF signal. This signal distortion may be quantified in terms of dynamic error vector magnitude (EVM). Dynamic EVM for RF transmitters including, but not limited to WiFi, is one of most challenges for RF PA front end modules. Without proper thermal compensation, the transmitted signal will have significant signal distortion that results in loss of data.

Thermally compensated bias 540 is configured to provide a thermally compensated bias signal to the power pre-amplifier PPA 512 and to also provide a thermally compensated bias signal to the power amplifier PA 514. The bias signals could be bias voltages or bias currents. In some embodiments, thermally compensated bias 540 has bias circuitry that provides the bias signals and heating circuitry that heats the bias circuitry in order to provide thermal compensation. The thermal compensation may be used to compensate for a temperature difference between the PPA 512 and/or PA 514 and the bias circuitry. If thermal compensation were not provided for the bias signals, then there could be signal distortion in the transmitted RF signal.

Thermally compensated bias 540 may be located far enough away from the PPA 512 and the PA 514 to avoid RF interference. However, as a result of this remote location, heat from the PPA 512 and the PA 514 does not have a significant impact on the temperature of the bias circuitry in the thermally compensated bias 540. Thermally compensated bias 540 provides temperature compensation to the bias signals that are provided to the PPA 512 and the PA 514. Thus, temperature differences between the bias circuitry and PPA 512 and/or PA 514 is compensated. Hence, distortion in the transmitted RF signal is reduced or eliminated.

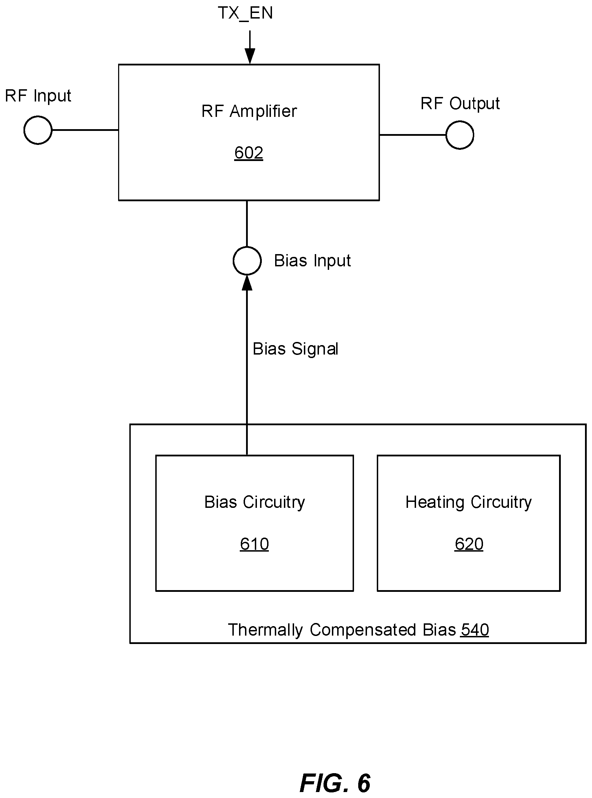

FIG. 6 depicts one embodiment of an apparatus configured to amplify an RF signal. The apparatus may be used in an RF transmitter such as any of transmitters 202, 302 or 502, but is not limited thereto. The apparatus includes an RF amplifier 602 and thermally compensated bias 540. In one embodiment, the RF amplifier 602 includes PPA 512 and PA 514. However, the RF amplifier 602 is not required to include both a pre-amplifier and a power amplifier. For example, the RF amplifier 602 could include one of PPA 512 or PA 514, but not both.

The RF amplifier 602 has an RF input that is configured to receive an RF signal. The RF amplifier 602 is configured to amplify the received RF signal, and to provide the amplified RF signal at RF output. The RF amplifier 602 has at least one bias input that is configured to receive a bias signal. The RF amplifier 602 could have multiple bias inputs. The bias signal(s) could be a bias current or a bias voltage.

In some embodiments, the RF amplifier 602 operates in a pulse mode. In an embodiment of the pulse mode, the RF amplifier 602 powers on/off in response to the transmit enable signal (TX_EN). The transmit enable signal may be provided by, for example, processor 208 or processor 308. Considerable power is saved by powering off the RF amplifier 602 when it is not being used to transmit a signal. However, the ambient temperature of the RF amplifier 602 may rise quickly when it is powered on. Without proper thermal compensation, this rise in ambient temperature could result in a change in gain of the RF amplifier 602 and RF signal distortion.

Thermally compensated bias 540 includes bias circuitry 610 and heating circuitry 620. The bias circuitry 610 is configured to generate a bias signal and to provide the bias signal to the bias input of the RF amplifier 602. The bias circuitry 610 may generate more than one bias signal, each of which is provided to a different bias input of the RF amplifier 602. The bias signal is temperature dependent, by which it is meant that the magnitude of the bias signal depends on the ambient temperature of the bias circuitry 610. In an embodiment, the bias circuitry 610 comprises one or more sets of bias transistors. Herein, a "bias transistor" is defined as a transistor that provides a bias signal (e.g., bias current, bias voltage). Each set of bias transistors has one or more transistors, and is configured to generate a bias signal. In an embodiment, the bias circuitry 610 transistors include bipolar junction transistors (BJTs).

The bias circuitry 610 may be enabled by the same transmit enable signal used to switch the RF amplifier 602 on/ff. With proper thermal compensation, the bias circuitry 610 may heat up much more slowly than the RF amplifier 602 when the RF amplifier 602 and bias circuitry 610 are enabled. The heating circuitry 620 in the thermally compensated bias 540 is thermodynamically coupled to the bias circuitry 610 and heats the bias circuitry 610 to compensate for a temperature difference between the RF amplifier 602 and the bias circuitry 610. In one embodiment, the heating circuitry 620 compensates for a temperature difference between the RF amplifier 602 and the bias circuitry 610 when the RF amplifier 602 and the bias circuitry 610 are first enabled during a pulse mode of operation. For example, the heating circuitry 620 may compensate for slower heating of the bias circuitry 610 than the RF amplifier 602. The amount of heating may be predetermined based on test or empirical data.

The thermal compensation thus regulates the bias signal(s) to the RF amplifier 602. For example, the thermal compensation regulates the magnitude of a DC bias current provided by the bias circuitry 610 to the bias input of the RF amplifier 602. Thus, the thermal compensation helps to stabilize the gain of the RF amplifier 602. For example, the thermal compensation leads to a more constant gain of the RF amplifier 602 while the RF is on during a pulse mode of operation. This stabilizing in the gain of the RF amplifier 602 reduces or eliminates distortion in the transmitted RF signal. Thus, the dynamic EVM is improved.

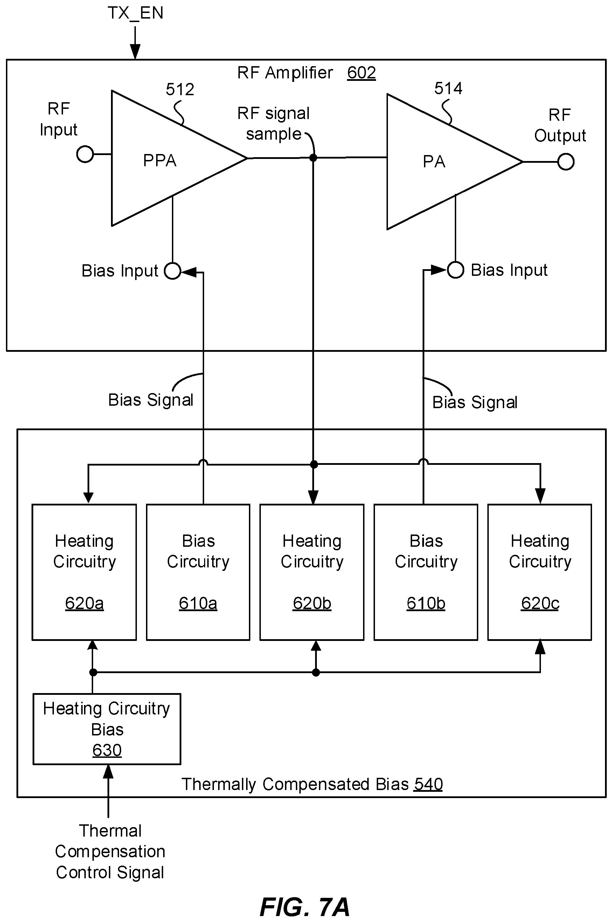

FIG. 7A depicts one embodiment of an apparatus configured to amplify an RF signal. FIG. 7A depicts further details of one embodiment of the apparatus of FIG. 6. The apparatus may be used in an RF transmitter such as any of RF transmitters 202, 302 or 502, but is not limited thereto. The RF amplifier 602 includes PPA 512 and PA 514. The bias circuitry 610 is divided into bias circuitry 610a and 610b. Bias circuitry 610a is configured to generate a bias signal, which is provided to the bias input of PPA 512. Bias circuitry 610b is configured to generate a bias signal, which is provided to the bias input of PA 514.

The heating circuitry 620 is located in close physical proximity to the bias circuitry 610 such that the heat that is generated by the heating circuitry 620 will heat the bias circuitry 610. In an embodiment, the heating circuitry 620 heats the bias circuitry 610 to compensate for a temperature difference between the bias circuitry 610 and the RF amplifier 602. In an embodiment, the heating circuitry 620 heats the bias circuitry 610 to compensate for a different heating rate between the bias circuitry 610 and the RF amplifier 602. In an embodiment, the heating circuitry 620 comprises one or more heating transistors. Herein, a heating transistor is defined as a transistor that generates heat and provides at least a portion of that heat to a bias transistor. In an embodiment, the heating circuitry 620 transistor(s) include one or more bipolar junction transistors (BJTs).

The heating circuitry 620 is divided into three portions 620a, 620b, 620c. In an embodiment, each portion 620a, 620b, 620c has one or more heating transistors. Herein the three portions may be referred to as heating circuitry 620a, heating circuitry 620b, and heating circuitry 620c. Heating circuitry 620a is located in close physical proximity to bias circuitry 610a, such that the heat that is generated by the heating circuitry 620a will heat bias circuitry 610a. Heating circuitry 620b is located between bias circuitry 610a, 610b and in close physical proximity to both bias circuitry 610a and bias circuitry 610b, such that the heat that is generated by the heating circuitry 620b will heat both bias circuitry 610a and bias circuitry 610b. Heating circuitry 620c is located in close physical proximity to bias circuitry 610b, such that the heat that is generated by the heating circuitry 620c will heat bias circuitry 610b. In another embodiment, heating circuitry 620 includes portion 620b, but does not include portions 620a or 620c. In another embodiment, heating circuitry 620 includes portions 620a and 620c, but does not include portion 620b.

Thermally compensated bias 540 has heating circuitry bias 630, which is configured to provide a bias signal to the heating circuitry 620. In one embodiment, heating circuitry bias 630 provides a DC bias current to the heating circuitry 620. Heating circuitry bias 630 may be referred to herein as a control circuit, or as a portion of a control circuit. In an embodiment, the DC bias current tracks the transmit enable signal such that the heating circuitry 620 will begin to heat when the RF amplifier 602 begins to heat. Therefore, the heating circuitry 620 will heat the bias circuity 610 such that the bias signals is thermally compensated. The thermal compensation control signal is configured to control the amount of heat generated by heating transistors while the RF amplifier 602 is powered on. In one embodiment, the thermal compensation control signal controls a magnitude of the DC bias current provided by the heating circuitry bias 630 to the heating transistors. In one embodiment, the magnitude of the DC bias current is at least one factor that controls the heat generated by the heating transistors. The thermal compensation control signal may be a digital signal or an analog signal. In some embodiments, the magnitude of the thermal compensation control signal depends on a target power of the RF signal that is output from the RF amplifier 602. Thus, in some embodiments, the magnitude of the DC bias current that is provided to the heating circuitry 620 depends on and is a function of the target power of the RF signal that is output from the RF amplifier 602. The target power output may be determined by, for example, processor 208/308 and provided to the RF amplifier 602. .

Thermally compensated bias 540 samples an amplified RF signal from the output of PPA 512 (labeled as RF signal sample). This sample may be a fraction of the magnitude of the amplified RF signal. That is, the magnitude of the sampled RF signal is proportional to the magnitude of the amplified RF signal, but may be smaller in magnitude. The sampled RF signal is provided as an input to the heating circuitry 620. The heating circuitry 620 generates heat in response to the magnitude of the sampled RF signal. The magnitude of the sampled RF signal may depend on ambient temperature of the RF amplifier 602. Therefore, the heating circuitry 620 will heat the bias circuity 610 such that the bias signals is thermally compensated.

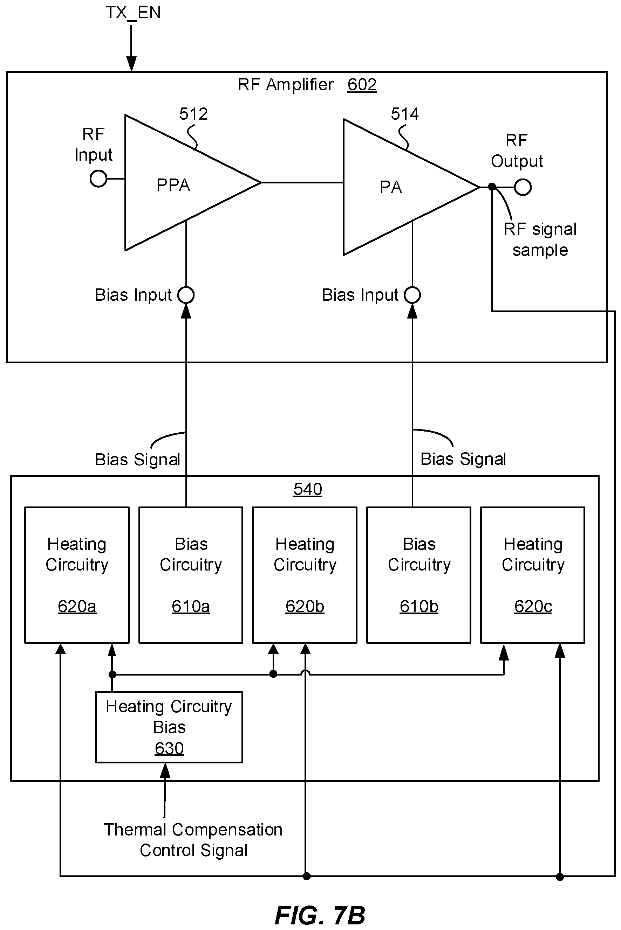

FIG. 7B depicts one embodiment of an apparatus configured to amplify an RF signal. FIG. 7B depicts further details of one embodiment of the apparatus of FIG. 6. The apparatus may be used in an RF transmitter such as any of RF transmitters 202, 302 or 502, but is not limited thereto. The apparatus of FIG. 7B is similar to the apparatus of FIG. 7A. However, thermally compensated bias 540 samples an amplified RF signal from the output of PA 514 (labeled as RF signal sample). The amplified RF signal is provided to the heating circuitry. The heating circuitry 620 heats the bias circuitry 610a, 610b based on the magnitude of the amplified RF signal from the PA 514.

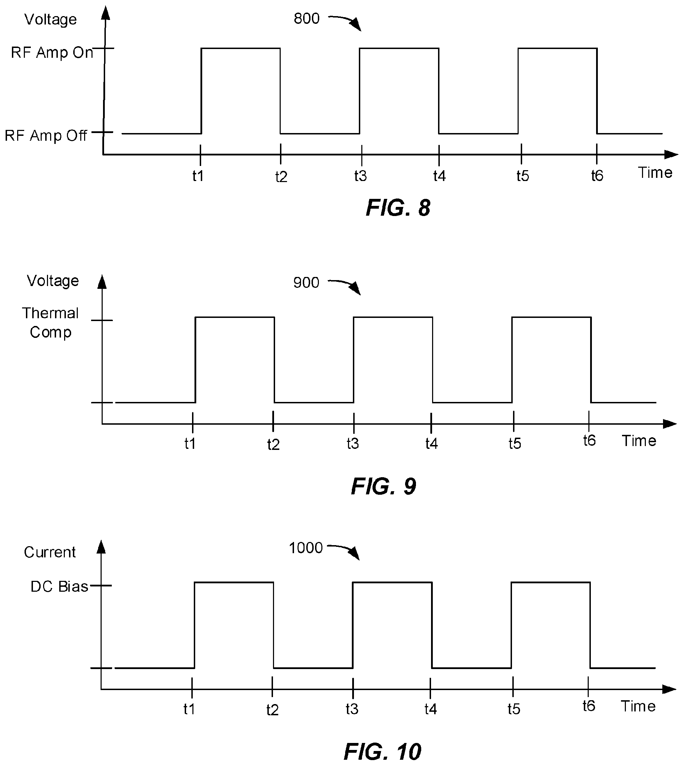

The RF amplifiers 602 in FIGs. 7A and 7B each receive a transmit enable signal, which may be provided by a processor (e.g., 208, 308). FIG. 8 depicts an example of the transmit enable signal (TX_EN) 800. FIG. 8 depicts voltage versus time for the transmit enable signal 800. The transmit enable signal 800 has a pulse shape, with rising edges at times t1, t3, and t5. The transmit enable signal 800 has falling edges at times t2, t4, and t6. The transmit enable signal may be provided by processor (e.g., 208, 308) to the RF amplifier 602. The transmit enable signal is used to cause the RF amplifier to operate in a pulse mode. In an embodiment, the RF amplifier 602 powers on when the transmit enable signal 800 is at the high level, and powers off when the transmitter enable signal 800 is at the low level (as indicated on the voltage axis in FIG. 8). An example of the high level is 1.5V. An example of the low level is 0V. In an embodiment, the transmit enable signal 800 has a duty cycle, which is defined as the percent of each cycle in which the transmit enable signal 800 is at the high level. Thus, the duty cycle corresponds to the percentage of time each cycle for which the RF amplifier 602 in the transmitter is powered on. The duty cycle is not required to be the same each period.

Thermally compensated bias 540 in FIGs. 7A and 7B each receive a thermal compensation signal. The thermal compensation signal is provided to the heating circuitry bias 630. FIG. 9 depicts an example of the thermal compensation signal 900. The thermal compensation signal 900 tracks the transmit enable signal 800, by which it is meant that it has the same duty cycle, with the pulses of the two signals rising and falling at the same time. For example, thermal compensation signal 900 has a pulse shape, with rising edges at times t1, t3, and t5. The thermal compensation signal 900 has falling edges at times t2, t4, and t6. Note that these times correspond to those depicted in FIG. 8 for the transmit enable signal 800. In an embodiment, the maximum value of the thermal compensation signal 900 (e.g., "Thermal Comp") indicates the amount of thermal compensation to be used. In one embodiment, memory (e.g., 206, 306) stores one or more parameters that specify the value for "Thermal Comp." In one embodiment, the transmit enable signal 800 is used for the thermal compensation signal 900.

The thermal compensation signal 900 is provided to the heating circuitry bias 630, which generates a bias signal based thereon. In one embodiment, the bias signal is a DC current. FIG. 10 depicts current versus time for the DC bias current 1000 generated by heating circuitry bias 630. The DC bias current 1000 tracks the transmit enable signal 800, by which it is meant that it has the same duty cycle, with the pulses of the two signals rising and falling at the same time. For example, the DC bias current 1000 has a pulse shape, with rising edges at times t1, t3, and t5. The DC bias current 1000 has falling edges at times t2, t4, and t6. Note that these times correspond to those depicted in FIG. 8 for the transmit enable signal 800. The DC bias current 1000 has maximum value of "DC Bias", which is the magnitude of a DC bias current provided to heating transistors. In one embodiment, heating bias circuitry 630 generates the DC bias current 1000 based on the thermal compensation signal 900. In some embodiments, the thermal compensation control signal 900 depends on the target power of the RF signal output by the RF amplifier 602. Thus, in some embodiments, the magnitude of the DC bias current 1000 depends on the target power of the RF signal output by the RF amplifier 602. For example, there may be several ranges of target power of the RF signal, such that a different DC bias current 1000 could be used for each target power range. In one embodiment, the DC bias current 1000 is larger in magnitude for higher target RF power.

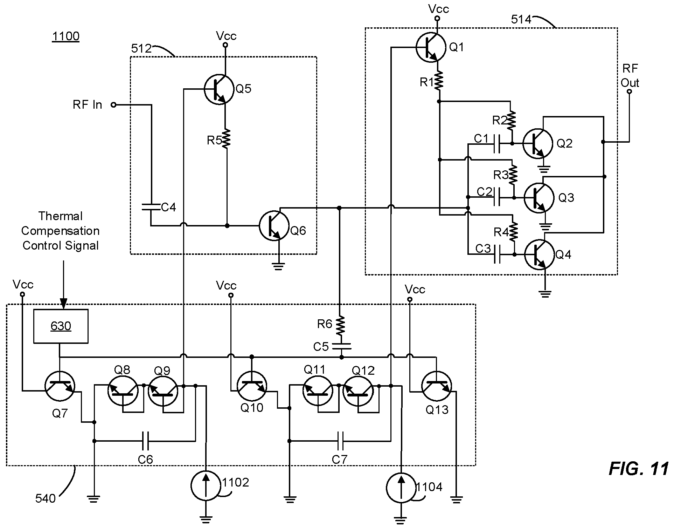

FIG. 11 is a circuit schematic of one embodiment of a circuit for amplifying an RF signal. The circuit 1100 depicts further details for one embodiment of PPA 512, PA 514, and thermally compensated bias 540. The circuit 1100 is consistent with the example of FIG. 7A in which the RF signal is sampled from the output of the PPA 512.

The PPA 512 includes transistors Q5 and Q8, resistor R5 and capacitor C4. Transistor Q5 may serve as a current buffer. The base of Q5 serves as a bias input for the PPA 512. Current from the transistor Q5 goes into the base of transistor Q6. Capacitor C4 is connected to the RF input, and is used for input impedance matching. Transistor Q6 amplifies the RF signal. The collector of Q6 is the RF output of PPA 512. The RF signal at the collector of Q6 may be referred to herein as a "pre-amplified RF signal."

The PA 514 includes transistors Q1, Q2, Q3, and Q4. The PA 514 includes resistors R1, R2, R3, and R4. The PA 514 also includes capacitors C1, C2, and C3. Capacitors C1, C2, and C3 are the RF signal input for the PA 514. Capacitors C1, C2, and C3 may perform at least some of the input impedance matching for the PA 514. Note that there may be additional impedance matching circuitry between the RF output of PPA 512 and the RF input of the PA 514. Transistor Q1 may serve as a current buffer. The base of Q1 serves as a bias input for the PA 514. Transistors Q2, Q3, and Q4 amplify the RF signal, and provide the amplified RF signal to the RF output (RF out). There may be more of these "amplification transistors" in the PA 514. The RF signal at the collectors of Q2, Q3, and Q4 may be referred to herein as a "power amplified RF signal."

Thermally compensated bias 540 has transistors Q7, Q8, Q9, Q10, Q11, Q12, and Q13. Thermally compensated bias 540 also has capacitors C5, C6, C7, as well as resistor R6.

Bias transistors Q8 and Q9 generate a bias signal (e.g., bias current), which is provided to the base of transistor Q5 in the PPA 512. Thus, bias transistors Q8 and Q9 provide a bias signal to the bias input of PPA 512. DC bias current source 1102 provides a DC bias current to Q9. Transistors Q8 and Q9, along with capacitor C6 are one embodiment of bias circuitry 610a.

Bias transistors Q11 and Q12 generate a bias signal (e.g., bias current), which is provided to the base of transistor Q1 in the PA 514. Thus, bias transistors Q11 and Q12 provide a bias signal to the bias input of PA 514. DC bias current source 1104 provides a DC bias current to Q12. Transistors Q11 and Q12, along with capacitor C7 are one embodiment of bias circuitry 610b.

The locations of transistors Q7 - Q13 in the schematic diagram represent their relative physical locations, in one embodiment. Heating transistor Q7 is located in close physical proximity to the set of bias transistors Q8 and Q9, such that the heat that is generated by the heating transistor Q7 will heat transistors Q8 and Q9. Stated another way, heating transistor Q7 is adjacent (i.e., next to) to the set of bias transistors Q8 and Q9, such that the heat that is generated by the heating transistor Q7 will heat bias transistors Q8 and Q9. Heating transistor Q7 is one embodiment of heating circuitry 620a.

Heating transistor Q10 is located between the set of bias transistors Q8 and Q9 and the set of bias transistors Q11 and Q12. Heating transistor Q10 is also in close physical proximity to both the set of bias transistors Q8 and Q9 and the set of bias transistors Q11 and Q12. Thus, the heat that is generated by the heating transistor Q10 will heat both the set of bias transistors Q8 and Q9 and the set of bias transistors Q11 and Q12. Stated another way, heating transistor Q10 is adjacent (i.e., next to) both the set of bias transistors Q8 and Q9 and the set of bias transistors Q11 and Q12, such that the heat that is generated by the heating transistor Q10 will heat both the set of bias transistors Q8 and Q9 and the set of bias transistors Q11 and Q12. Transistor Q10 is one embodiment of heating circuitry 620b.

Heating transistor Q13 is located in close physical proximity to the set of bias transistors Q11 and Q12, such that the heat that is generated by heating transistor Q13 will heat bias transistors Q11 and Q12. Stated another way, heating transistor Q13 is adjacent (i.e., next to) to the set of bias transistors Q11 and Q12, such that the heat that is generated by the heating transistor Q13 will heat bias transistors Q11 and Q12. Transistor Q13 is one embodiment of heating circuitry 620c.

In one embodiment, heating transistors Q7 and Q10 work together to heat bias transistors Q8 and Q9. Heating transistor Q7 is on one side of the pair Q8, Q9, with Q10 on the opposite side of pair Q8, Q9. In one embodiment, heating transistors Q13 and Q10 work together to heat bias transistors Q11 and Q12. Heating transistor Q13 is on one side of the pair Q11, Q12, with Q10 on the opposite side of pair Q11, Q12. Thermally compensated bias 540 includes heating circuitry bias 630, which is configured to provide a bias signal (e.g., bias current) to the base terminals of heating transistors Q7, Q10, and Q13. In one embodiment, the heating circuitry bias 630 provides a DC bias current to the base terminals of Q7, Q10, and Q13. The DC bias current tracks the transmit enable signal. Thus, when the PPA 512 and PA 514 are enabled (on), Q7, Q10, and Q13 receive a bias current from the heating circuitry bias 630. However, when the PPA 512 and PA 514 are not enabled (off), Q7, Q10, and Q13 do not receive a DC bias current from the heating circuitry bias 630. Heating circuitry bias 630 inputs a thermal compensation control signal, which instructs heating circuitry bias 630 when the DC bias current should and should not be provided to Q7, Q10, and Q13.

Thermally compensated bias 540 samples the RF signal at the output of the PPA 512. In one embodiment, thermally compensated bias 540 samples a fraction of the power of the RF signal. Note that the sampling of the RF signal does not have a significant impact on overall power consumption of the circuit 1100. For example, by sampling a small fraction of the power of the RF signal, the impact on overall power consumption can be minimized. To sample the RF signal, resistor R6 is connected to the collector of transistor Q6. Capacitor C5 is connected between resistor R6 and the base terminals of transistors Q7, Q10, and Q13. Therefore, the sampled RF signal (which may be some fraction of the magnitude of the RF signal) is provided to the base terminals of transistors Q7, Q10, and Q13. Therefore, heating transistors Q7, Q10, and Q13 will heat in response to the magnitude of the sampled RF signal. The amount of the heat generated is adjustable through the DC bias current received from the heating circuitry bias 630. In an embodiment, the thermal compensation control signal 900 specifies the magnitude of the DC bias current 1000 to the heating circuit bias 630.

As noted herein, the ambient temperature of the PPA 512 and/or the PA 514 may rise quickly when the PPA 512 and/or the PA 514 powers on (e.g., is enabled). The ambient temperature of the PPA 512 and/or the PA 514 impacts the base-emitter turn on voltage. In some embodiments, the base-emitter turn on voltage of transistors in the PPA 512 and/or the PA 514 is relatively high when the ambient temperature is lower, and drops as the ambient temperature increases. Even without thermal compensation, the transistors in the bias circuitry (e.g., Q8, Q9, Q11, Q12) may undergo a similar effect in the base-emitter turn on voltage, but at a different rate due to the slower rise in ambient temperature to the bias circuitry. Such differences could, without thermal compensation, lead to instability in the gain of PPA 512 and/or the PA 514. For example, the gain could start relatively low, then rise up rapidly. It is possible for there to then be some settling down (lowering) in the gain of the PPA 512 and/or the PA 514. However, the heating transistors Q7, Q10, Q13 provide thermal compensation that compensates for temperature differences between transistors in the bias circuitry (e.g., Q8, Q9, Q11, Q12) and transistors in the PPA 512 and/or the PA 514. Hence, the heating transistors Q7, Q10, Q13 help to stabilize gain in the PPA 512 and/or the PA 514. Therefore, RF signal distortion is reduced or eliminated.

Many variations of the circuit 1100 are possible. In one embodiment, additional heating transistors can be added. For example, one or more additional heating transistors can be added next to Q10, such that there are two or more heating transistors between the pair Q8, Q9 and the pair Q11, Q12. Similarly, one or more additional heating transistors can be added next to Q7 or Q13. It is not required that all of Q7, Q10, and Q13 be used. Any subset of Q7, Q10, and Q13 may be used. In one embodiment, there are one or more heating transistors between the pair Q8, Q9 and the pair Q11, Q12; however, transistors Q7 and Q13 are optional.

It is not required that the bias signal provided to both of PPA 512 and PA 514 be thermally compensated. In one embodiment, the bias signal from the pair Q8, Q9 is thermally compensated, but thermal compensation for the bias signal from the pair Q11, Q12 is optional. In one embodiment, the bias signal from the pair Q11, Q12 is thermally compensated, but thermal compensation for the bias signal from the pair Q8, Q9 is optional.

Another possible variation of circuit 1100 is to sample the RF signal from the RF output of PA 514, as opposed from the RF output of PPA 512. Thus, a sampled RF signal from PA 514 may be provided to the base terminals of transistors Q7, Q10, and Q13 (instead of the RF signal from the RF output of PPA 512).

Another possible variation of circuit 1100 is to replace some or all of the bipolar junction transistors with another type of transistor, such as a MOSFET.

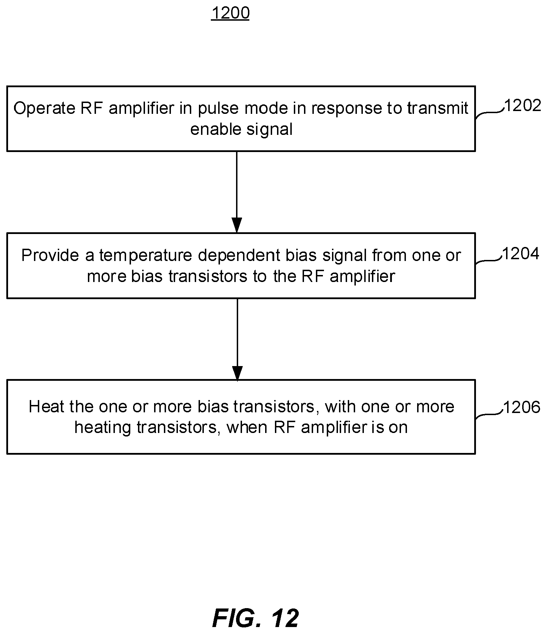

FIG. 12 depicts a flowchart of one embodiment of a process of amplifying an RF signal. The process 1200 may be implemented by an RF transmitter (e.g., 202, 302, 502). In one embodiment, the process 1200 is implemented by UE 110. In one embodiment, the process 1200 is implemented by base station 170. The base station 170 may include a wireless access point. The process may be implemented by the apparatus in FIGs. 6, 7A, or 7B, but is not limited thereto. In one embodiment, the process 1200 is implemented by circuit 1100. In one embodiment, the RF signal transmission is compliant with an IEEE 802.11 protocol. For example, process 1200 may be used to transmit a Wi-Fi signal.

Step 1202 includes operating an RF amplifier 602 in a pulse mode in response to a transmit enable signal (TX_EN). In the pulse mode, the RF amplifier 602 powers on and off in response to the transmit enable signal. The transmit enable signal may be provided by a processor (e.g., processor 208, 308).

Step 1204 includes providing a temperature dependent bias signal from one or more bias transistors to a bias input of the RF amplifier 602. In one embodiment, bias circuitry 610a provides a bias signal to RF input of PPA 512. With reference to FIG. 11, in one embodiment, bias transistors Q8 and Q9 provide a bias signal to the base of transistor Q5 in PPA 512. In one embodiment, bias circuitry 610b provides a bias signal to RF input of PA 514. With reference to FIG. 11, in one embodiment, bias transistors Q11 and Q12 provide a bias signal to the base of transistor Q1 in PA 514. A factor in the bias signal being temperature dependent is that the bias circuitry 610a contains one or more bias transistors, whose operation is temperature dependent.

Step 1206 includes heating the one or more bias transistors, with one or more heating transistors, when the RF amplifier 602 is powered on. The one or more heating transistors may be in close physical proximity to the one or more bias transistors in order to heat the one or more bias transistors. Heating the one or more bias transistors helps to compensate for a temperature difference between the RF amplifier 602 and the one or more bias transistors. Heating the one or more bias transistors helps to compensate for a temperature difference between the RF amplifier 602 and the one or more bias transistors. Heating the one or more bias transistors helps to compensate for a different heating rate of the RF amplifier 602 and the one or more bias transistors. Thus, the thermal compensation helps to stabilize the gain of the RF amplifier 602. For example, the thermal compensation leads to a more constant gain of the RF amplifier 602 over the duration of a duty cycle during a pulse mode of operation. This stabilizing in the gain of the RF amplifier 602 reduces or eliminates distortion in the transmitted RF signal. Thus, the dynamic EVM is improved.

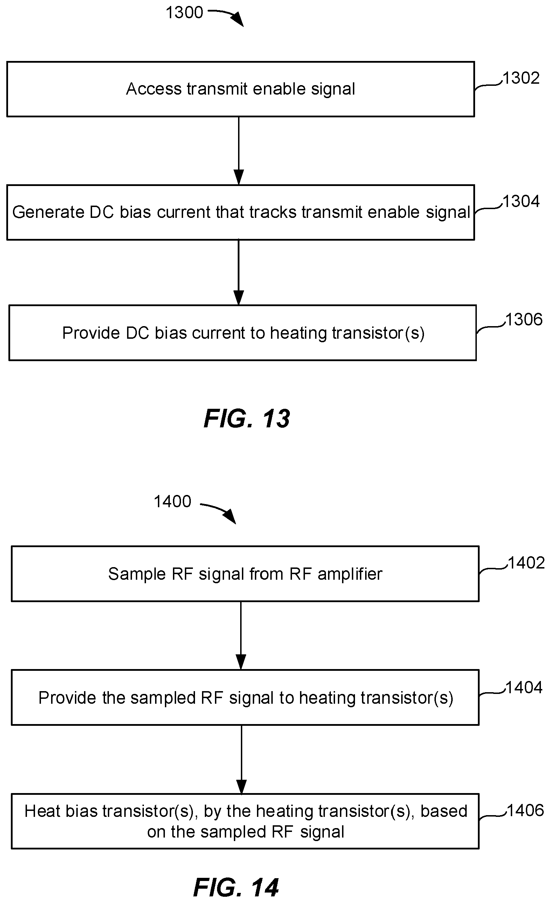

FIG. 13 depicts one embodiment of a flowchart of a process 1300 of biasing heating transistors in thermally compensated bias 540. The process 1300 may be implemented in one embodiment of step 1206 of process 1200. With reference to the circuit 1100 in FIG. 11, the process 1300 of FIG. 13 may be used to bias heating transistors Q7, Q10, and Q13. The process 1300 may be implemented by an RF transmitter (e.g., 202, 302, 502). In one embodiment, the process 1300 is implemented by UE 110. In one embodiment, the process 1300 is implemented by base station 170. The process may be implemented by the apparatus in FIGs. 6, 7A, or 7B, but is not limited thereto. In one embodiment, the process 1400 is implemented by circuit 1100.

Step 1302 includes accessing a transmitter enable signal. FIG. 8 depicts one embodiment of a transmitter enable signal 800. The transmitter enable signal may be provided by a processor (e.g., 208, 308).

Step 1304 includes generating a DC bias current that tracks the transmitter enable signal. Heating circuitry bias 630 may generate the DC bias current. FIG. 10 depicts an example of the DC bias current 1000. FIG. 10 depicts current versus time for the DC bias current 1000. The DC bias current 1000 tracks the transmit enable signal 800. In one embodiment, the low level of the DC bias current 1000 is 0 amperes. In one embodiment, the high level of the DC bias current 1000 is between 1 mA - 10 mA; however, the high level of the DC bias current 1000 could be less than 1 mA or greater than 10 mA. In an embodiment, the magnitude of the DC bias current 1000 is used to regulate how much heat is generated by the heating circuitry 620 (e.g., heating transistors Q7, Q10, Q13). In some embodiments, the magnitude of the DC bias current 1000 may be determined experimentally.

In some embodiments, the magnitude of the DC bias current 1000 depends on the target power of the RF signal that is output by the RF amplifier 602. In one embodiment, a processor (e.g., 208, 308) determines the magnitude of the DC bias current 1000 based on the target power. In one embodiment, the processor accesses a table stored in memory (e.g., 206, 306) to determine the magnitude of the DC bias current 1000. The table could directly indicate the magnitude of the DC bias current 1000 for two or more target power ranges, or indirectly indicate the magnitude of the DC bias current 1000 by specifying a value for the thermal compensation control signal for two or more target power ranges. Determining the magnitude of the DC bias current 1000, based on the target power output of the RF signal that is output by the RF amplifier 602, is not limited to a table-driven approach.

Step 1306 includes providing the DC bias current to one or more heating transistors. In one embodiment, heating circuitry bias 630 provides the DC bias current to heating transistors Q7, Q10, and Q13. The DC bias current may be provided to respective base terminals of Q7, Q10, and Q13. In an embodiment, the magnitude of the DC bias current is a factor that controls an amount of heating provided by the heating transistors Q7, Q10, and Q13. Thus, adjusting the magnitude of the DC bias current may be used to control an amount of heating provided by the heating transistors Q7, Q10, and Q13.

FIG. 14 depicts a flowchart of one embodiment of a process of providing an amplified RF signal to one or more heating transistors. The process 1400 may be implemented in one embodiment of step 1206 of process 1200. The process 1400 may be implemented by an RF transmitter (e.g., 202, 302, 502). In one embodiment, the process 1400 is implemented by UE 110. In one embodiment, the process 1400 is implemented by base station 170. The base station 170 may include a wireless access point. The process may be implemented by the apparatus in FIGs. 6, 7A, or 7B, but is not limited thereto. In one embodiment, the process 1400 is implemented by circuit 1100.

Step 1402 includes sampling an RF signal from an RF amplifier 602. In one embodiment, the RF signal is sampled from the output of PPA 512. In one embodiment, the RF signal is sampled from the output of PA 514. In one embodiment, the RF signal is sampled by sampling circuitry in thermally compensated bias 540. With reference to FIG. 11, the sampling circuitry may include R6 and C5. The sampling circuitry may be referred to herein as a control circuit, or as a portion of a control circuit.

Step 1404 includes providing the sampled RF signal to heating transistor(s). With reference to FIG. 11, the sampled RF signal is provided to the respective base terminals of transistors Q7, Q10, and Q13. Each heating transistor Q7, Q10, and Q13 will thus respond to the sampled RF signal. For example, the collector to emitter current of each transistor Q7, Q10, and Q13 may respond to the sampled RF signal. Thus, each transistor Q7, Q10, and Q13 will generate an amount of heat that depends on the magnitude of the sampled RF signal.

Step 1406 includes the heating transistor(s) heating the bias transistor(s) based on the sampled RF signal. The heating transistor(s) may be in close physical proximity to the bias transistor(s) in order to heat the bias transistor(s).

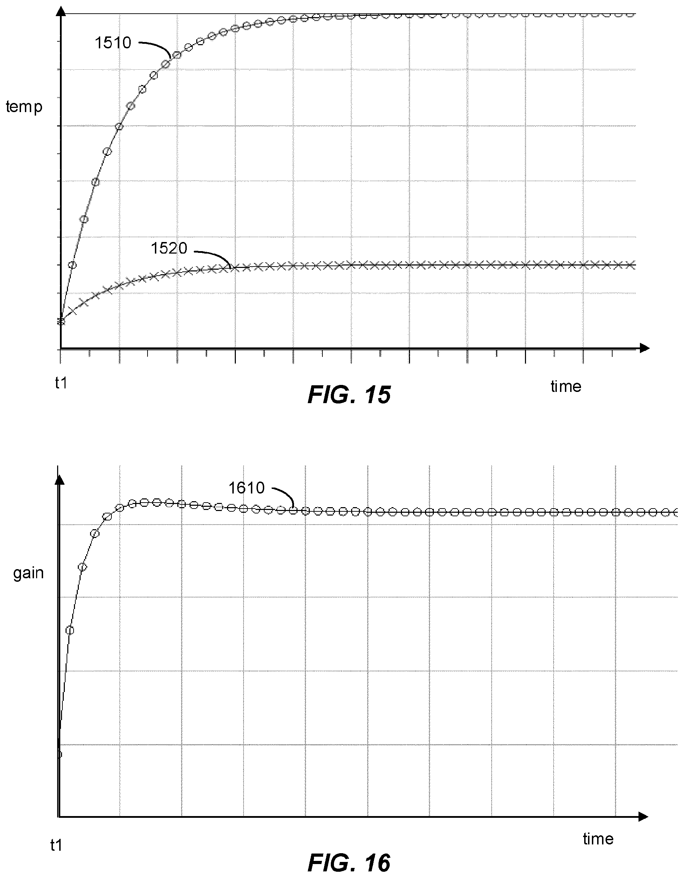

FIG. 15 is a graph that depicts ambient temperature for the RF amplifier 602 and the bias circuitry 610 if no thermal compensation were to be used. Plot 1510 depicts ambient temperature versus time for the amplifier 602. Plot 1520 depicts ambient temperature versus time for the bias circuitry 610 if no thermal compensation were to be used. Time t1 is when the RF amplifier 602 is enabled, and hence powers on and begins to heat. The bias circuitry 610 may also power on when the RF amplifier 602 is enabled. The ambient temperature for the amplifier 602 rises much faster than the ambient temperature for the bias circuitry 610.

FIG. 16 is a graph that depicts gain of an RF amplifier versus time, if no thermal compensation were to be used. Plot 1610 depicts RF amplifier versus time, if no thermal compensation were to be used. Time t1 is when the RF amplifier is enabled, and hence powers on and begins to heat. The gain changes considerable over time. The RF amplifier gain rises considerable as the RF amplifier heats up, eventually leveling off. This change in gain can lead to RF signal distortion. However, the RF amplifier needs to transmit an RF signal as soon as it is enable to transit. Hence, the gain profile in FIG. 16 could lead to a poor dynamic EVM for RF signal transmission including, but not limited to, Wi-Fi signal transmission.

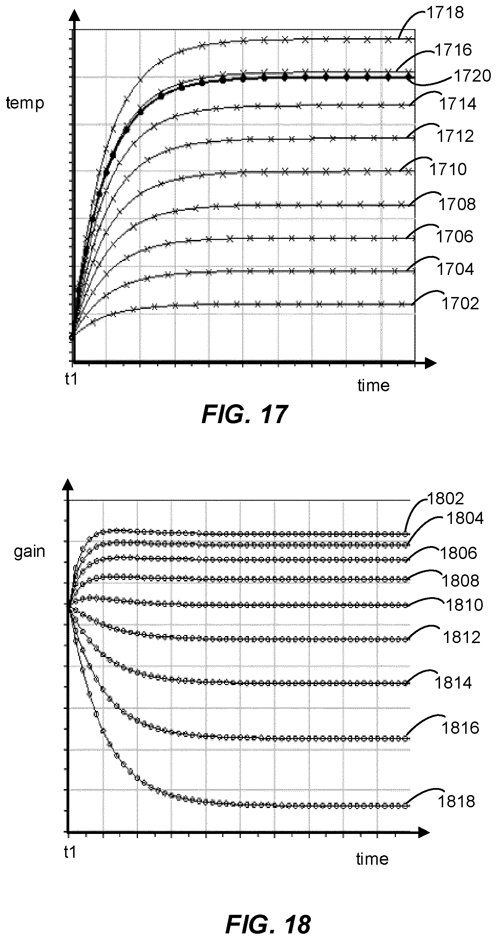

FIG. 17 is a graph that depicts ambient temperature for the RF amplifier 602 and the bias circuitry 610 if various levels of thermal compensation were to be used. Plot 1720 depicts temperature versus time for the RF amplifier 602. Plots 1702 - 1718 depict temperature versus time for the bias circuitry 610 if various levels of thermal compensation were to be used. The bias circuitry 610 will heat to higher temperatures if more thermal compensation is used. In one embodiment, the amount of thermal compensation depends on both the magnitude of the DC bias current provided by heating circuitry bias 630 to the heating transistors, as well as the fraction of the RF power that is sampled from RF amplifier 602. The fraction of the RF power that is sampled from RF amplifier 602 may be adjusted based on factors such as the values of resistor R6 and capacitor C5 (see circuit 1100).

FIG. 18 is a graph that depicts gain of an RF amplifier 602 versus time, if various levels of thermal compensation were to be used. Plots 1802 - 1818 depict RF amplifier gain versus time, if the various levels of thermal compensation in FIG. 17 were to be used. Plot 1802 corresponds to plot 1702, and is for the least amount of thermal compensation in FIG. 17. Plot 1804 corresponds to plot 1704; plot 1806 corresponds to plot 1706; plot 1808 corresponds to plot 1708; plot 1810 corresponds to plot 1710; plot 1812 corresponds to plot 1712; plot 1814 corresponds to plot 1714; plot 1816 corresponds to plot 1716; and plot 1818 corresponds to plot 1718.

The gain for plot 1810 is relatively constant over time. Hence, the thermal compensation associated with plot 1710 may be selected to provide for a relatively constant gain in the RF amplifier 602. The plots for FIGs. 17 and 18 may be determined experimentally, by applying different amount of thermal compensation. The magnitude of DC bias current that is generated by the heating circuitry bias 630 may be selected based on analysis of the plots of FIGs. 17 and 18. Suitable values for resistor R6 and/or capacitor C5 may be selected based on analysis of the plots of FIGs. 17 and 18.

The technology described herein can be implemented using hardware, software, or a combination of both hardware and software. The software used is stored on one or more of the processor readable storage devices described above to program one or more of the processors to perform the functions described herein. The processor readable storage devices can include computer readable media such as volatile and non-volatile media, removable and non-removable media. By way of example, and not limitation, computer readable media may comprise computer readable storage media and communication media. Computer readable storage media may be implemented in any method or technology for storage of information such as computer readable instructions, data structures, program modules or other data. Examples of computer readable storage media include RAM, ROM, EEPROM, flash memory or other memory technology, CD-ROM, digital versatile disks (DVD) or other optical disk storage, magnetic cassettes, magnetic tape, magnetic disk storage or other magnetic storage devices, or any other medium which can be used to store the desired information and which can be accessed by a computer. A computer readable medium or media does (do) not include propagated, modulated or transitory signals.

Communication media typically embodies computer readable instructions, data structures, program modules or other data in a propagated, modulated or transitory data signal such as a carrier wave or other transport mechanism and includes any information delivery media. The term "modulated data signal" means a signal that has one or more of its characteristics set or changed in such a manner as to encode information in the signal. By way of example, and not limitation, communication media includes wired media such as a wired network or direct-wired connection, and wireless media such as RF and other wireless media. Combinations of any of the above are also included within the scope of computer readable media.

In alternative embodiments, some or all of the software can be replaced by dedicated hardware logic components. For example, and without limitation, illustrative types of hardware logic components that can be used include Field-programmable Gate Arrays (FPGAs), Application-specific Integrated Circuits (ASICs), Application-specific Standard Products (ASSPs), System-on-a-chip systems (SOCs), Complex Programmable Logic Devices (CPLDs), special purpose computers, etc. In one embodiment, software (stored on a storage device) implementing one or more embodiments is used to program one or more processors. The one or more processors can be in communication with one or more computer readable media/ storage devices, peripherals and/or communication interfaces.

It is understood that the present subject matter may be embodied in many different forms and should not be construed as being limited to the embodiments set forth herein. Rather, these embodiments are provided so that this subject matter will be thorough and complete and will fully convey the disclosure to those skilled in the art. Indeed, the subject matter is intended to cover alternatives, modifications and equivalents of these embodiments, which are included within the scope and spirit of the subject matter as defined by the appended claims. Furthermore, in the following detailed description of the present subject matter, numerous specific details are set forth in order to provide a thorough understanding of the present subject matter. However, it will be clear to those of ordinary skill in the art that the present subject matter may be practiced without such specific details.

Aspects of the present disclosure are described herein with reference to flowchart illustrations and/or block diagrams of methods, apparatuses (systems) and computer program products according to embodiments of the disclosure. It will be understood that each block of the flowchart illustrations and/or block diagrams, and combinations of blocks in the flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable instruction execution apparatus, create a mechanism for implementing the functions/acts specified in the flowchart and/or block diagram block or blocks.

The description of the present disclosure has been presented for purposes of illustration and description, but is not intended to be exhaustive or limited to the disclosure in the form disclosed. Many modifications and variations will be apparent to those of ordinary skill in the art without departing from the scope and spirit of the disclosure. The aspects of the disclosure herein were chosen and described in order to best explain the principles of the disclosure and the practical application, and to enable others of ordinary skill in the art to understand the disclosure with various modifications as are suited to the particular use contemplated.

For purposes of this document, each process associated with the disclosed technology may be performed continuously and by one or more computing devices. Each step in a process may be performed by the same or different computing devices as those used in other steps, and each step need not necessarily be performed by a single computing device.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. An apparatus for amplifying a radio frequency, RF, signal, the apparatus comprising:
an RF amplifier (602) configured to receive a temperature dependent bias input and the RF signal, the RF amplifier (602) configured to amplify the RF signal based on a transmit enable signal (TX_EN);
one or more bias transistors (610) configured to generate the temperature dependent bias signal; the apparatus **characterized in that** it further comprises:
one or more heating transistors (620) configured to heat the one or more bias transistors (610); and
a control circuit (630) configured to cause the one or more heating transistors (620) to heat the one or more bias transistors (610) while the RF amplifier (602) is powered on to compensate temperature differences between the one or more bias transistors (610) and the RF amplifier (602).

2. The apparatus of claim 1, wherein the control circuit (630) is configured to:
generate a DC bias current that tracks the transmit enable signal; and
provide the DC bias current to the one or more heating transistors (620) to cause the one or more heating transistors (620) to heat the one or more bias transistors (610) while the RF amplifier (602) powered on.

3. The apparatus of claim 2, wherein the control circuit (630) is configured to;
provide heating compensation for the one or more bias transistors (610) based on a received control signal that is generated by a processor based upon a specified parameter; and
generate the DC bias current based on the control signal, wherein a magnitude of the DC bias current controls an amount of heat generated by the heating transistors (620) to heat the one or more bias transistors (610) while the RF amplifier (602) is powered on.

4. The apparatus of claim 2 or 3, wherein the control circuit (630) is configured to:
determine a magnitude of the DC bias current based on a target power of the amplified RF signal output by the RF amplifier (602).

5. The apparatus of any of claims 1 to 4, wherein:
the control circuit (630) is configured to sample the amplified RF signal from the RF amplifier (602) and provide the sampled amplified RF signal to the one or more heating transistors (620); and
the one or more heating transistors (620) are configured to heat the one or more bias transistors (610) based on a magnitude of the amplified RF signal while the RF amplifier (602) is powered on.

6. The apparatus of any of claims 2 to 5, wherein:
the one or more heating transistors (620) comprise one or more bipolar junction transistors;
the control circuit (630) provides the DC bias current to a base of each of the one or more bipolar junction transistors; and
the control circuit (630) provides the amplified RF signal to the base of each of the one or more bipolar junction transistors.

7. The apparatus of any of claims 1 to 6, wherein the one or more heating transistors (620) comprise a first transistor on a first side of the one or more bias transistors and a second transistor on a second side of the one or more bias transistors (610), wherein the second side is opposite the first side.

8. The apparatus of any of claims 1 to 7, wherein:
the RF amplifier (602) comprises a pre-amplification (PPA) stage having a first RF input, the bias input which is a first bias input, and a first RF output;
the RF amplifier (602) comprises a power amplification (PA) stage having a second RF input coupled to the first RF output, a second bias input and a second RF output;
the one or more bias transistors (610) is configured to provide a first bias signal to the first bias input of the pre-amplification (PPA) stage and to provide a second bias signal to the second bias input of the power amplification (PA) stage; and
the control circuit (630) is configured to sample the amplified RF signal at the first RF output, wherein the one or more heating transistors (620) is configured to heat the one or more bias transistors (620) based on a magnitude of the amplified RF signal at the first RF output.

9. The apparatus of any of claims 1 to 7, wherein:
the RF amplifier (602) comprises a pre-amplification (PPA) stage having a first RF input, a first bias input, and a first RF output;
the RF amplifier (602) comprises a power amplification (PA) stage having a second RF input coupled to the first RF output, a second bias input and a second RF output;
the one or more bias transistors (610) is configured to provide a first bias signal to the first bias input of the pre-amplification (PPA) stage and to provide a second bias signal to the second bias input of the power amplification (PA) stage; and
the control circuit (630) is configured to sample the amplified RF signal at the second RF output, wherein the one or more heating transistors (620) is configured to heat the one or more bias transistors (610) based on a magnitude of the amplified RF signal at the second RF output.

10. The apparatus of claim 8 or 9, wherein:
the one or more bias transistors (610) comprise a first set of one or more bias transistors configured to provide the first bias signal to the pre-amplification (PPA) stage and a second set of one or more bias transistors configured to provide the second bias signal to the power amplification (PA) stage; and
the one or more heating transistors (620) comprise a first heating transistor between the first set of one or more bias transistors and the second set of one or more bias transistors.

11. The apparatus of any of claims 8 to 10, wherein the one or more heating transistors (620) further comprises:
a second heating transistor on a first side of the first set of one or more bias transistors that is opposite a second side of the first set of one or more bias transistors that is adjacent to the first heating transistor; and
a third heating transistor on a first side of the second set of one or more bias transistors that is opposite a second side of the second set of one or more bias transistors that is adjacent to the first heating transistor.

12. A method (1200) for amplifying a radio frequency, RF, signal, the method comprising:
operating (1202) an RF amplifier in a mode in which the RF amplifier powers on and off in response to a transmit enable signal;
amplifying the RF signal, by the RF amplifier, when the RF amplifier is powered on;
providing (1204) a temperature dependent bias signal from one or more bias transistors to a bias input of the RF amplifier when the RF amplifier is powered on; and
heating (1206) the one or more bias transistors, by one or more heating transistors, while the RF amplifier is powered on to compensate temperature differences between the one or more bias transistors (610) and the RF amplifier (602).

13. The method of claim 12, further comprising:
generating a DC bias current that tracks the transmit enable signal; and
providing the DC bias current to the one or more heating transistors while the RF amplifier is powered on.

14. The method of claim 13, further comprising:
accessing a parameter upon which an amount of heating compensation for the one or more bias transistors is based; and
generating the DC bias current based on the parameter, wherein a magnitude of the DC bias current controls an amount of heat generated by the heating transistors to heat the one or more bias transistors while the RF amplifier is powered on.

15. The method of claim 12 or 13, further comprising:
providing, to the RF amplifier, a target power of the amplified the RF signal; and
determining a magnitude of the DC bias current based on the target power of the amplified the RF signal.

## Patentansprüche

1. Einrichtung zum Verstärken eines Hochfrequenz(HF)-Signals, wobei die Einrichtung umfasst:
einen HF-Verstärker (602), der konfiguriert ist, um einen temperaturabhängigen Bias-Eingang und das HF-Signal zu empfangen, wobei der HF-Verstärker (602) konfiguriert ist, um das HF-Signal basierend auf einem Sendefreigabesignal (TX_EN) zu verstärken;
einen oder mehrere Bias-Transistoren (610), die konfiguriert sind, um das temperaturabhängige Bias-Signal zu erzeugen; wobei die Einrichtung **dadurch gekennzeichnet ist, dass** sie ferner umfasst:
einen oder mehrere Heiztransistoren (620), die konfiguriert sind, um den einen oder die mehreren Bias-Transistoren (610) zu erwärmen; und
eine Steuerschaltung (630), die konfiguriert ist, um zu bewirken, dass der eine oder die mehreren Heiztransistoren (620) den einen oder die mehreren Bias-Transistoren (610) erwärmen, während der HF-Verstärker (602) eingeschaltet ist, um Temperaturunterschiede zwischen dem einen oder den mehreren Bias-Transistoren (610) und dem HF-Verstärker (602) auszugleichen.

2. Einrichtung nach Anspruch 1, wobei die Steuerschaltung (630) ferner konfiguriert ist zum:
Erzeugen eines DC-Bias-Stroms, der dem Sendefreigabesignal folgt; und
Bereitstellen des DC-Bias-Stroms an den einen oder die mehreren Heiztransistoren (620), um zu bewirken, dass der eine oder die mehreren Heiztransistoren (620) den einen oder die mehreren Bias-Transistoren (610) erwärmen, während der HF-Verstärker (602) eingeschaltet ist.

3. Einrichtung nach Anspruch 2, wobei die Steuerschaltung (630) ferner konfiguriert ist zum:
Bereitstellen eines Heizausgleichs für den einen oder die mehreren Bias-Transistoren (610) basierend auf einem empfangenen Steuersignal, das durch einen Prozessor basierend auf einem spezifizierten Parameter erzeugt wird; und
Erzeugen des DC-Bias-Stroms basierend auf dem Steuersignal, wobei eine Größe des DC-Bias-Stroms eine Wärmemenge steuert, die durch die Heiztransistoren (620) erzeugt wird, um den einen oder die mehreren Bias-Transistoren (610) zu erwärmen, während der HF-Verstärker (602) eingeschaltet ist.

4. Einrichtung nach Anspruch 2 oder 3, wobei die Steuerschaltung (630) konfiguriert ist zum:
Bestimmen einer Größe des DC-Bias-Stroms basierend auf einer Zielleistung des durch den HF-Verstärker (602) ausgegebenen verstärkten HF-Signals.

5. Einrichtung nach einem der Ansprüche 1 bis 4, wobei:
die Steuerschaltung (630) konfiguriert ist, um das verstärkte HF-Signal von dem HF-Verstärker (602) abzutasten und das abgetastete verstärkte HF-Signal an den einen oder die mehreren Heiztransistoren (620) bereitzustellen; und
der eine oder die mehreren Heiztransistoren (620) konfiguriert sind, um den einen oder die mehreren Bias-Transistoren (610) basierend auf einer Größe des verstärkten HF-Signals zu erwärmen, während der HF-Verstärker (602) eingeschaltet ist.

6. Einrichtung nach einem der Ansprüche 2 bis 5, wobei:
der eine oder die mehreren Heiztransistoren (620) einen oder mehrere Bipolartransistoren umfassen;
die Steuerschaltung (630) den DC-Bias-Strom an eine Basis jedes des einen oder der mehreren Bipolartransistoren bereitstellt; und
die Steuerschaltung (630) das verstärkte HF-Signal an die Basis jedes des einen oder der mehreren Bipolartransistoren bereitstellt.

7. Einrichtung nach einem der Ansprüche 1 bis 6, wobei der eine oder die mehreren Heiztransistoren (620) einen ersten Transistor auf einer ersten Seite des einen oder der mehreren Bias-Transistoren und einen zweiten Transistor auf einer zweiten Seite des einen oder der mehreren Bias-Transistoren (610) umfassen, wobei die zweite Seite der ersten Seite gegenüberliegt.

8. Einrichtung nach einem der Ansprüche 1 bis 7, wobei:
der HF-Verstärker (602) eine Vorverstärkungs(PPA)-Stufe, die einen ersten HF-Eingang aufweist, den Bias-Eingang, der ein erster Bias-Eingang ist, und einen ersten HF-Ausgang umfasst;
der HF-Verstärker (602) eine Leistungsverstärkungs(PA)-Stufe, die einen zweiten HF-Eingang aufweist, der mit dem ersten HF-Ausgang gekoppelt ist, einen zweiten Bias-Eingang und einen zweiten HF-Ausgang umfasst;
der eine oder die mehreren Bias-Transistoren (610) konfiguriert sind, um ein erstes Bias-Signal an den ersten Bias-Eingang der Vorverstärkungs(PPA)-Stufe bereitzustellen und ein zweites Bias-Signal an den zweiten Bias-Eingang der Leistungsverstärkungs(PA)-Stufe bereitzustellen; und
die Steuerschaltung (630) konfiguriert ist, um das verstärkte HF-Signal an dem ersten HF-Ausgang abzutasten, wobei der eine oder die mehreren Heiztransistoren (620) konfiguriert sind, um den einen oder die mehreren Bias-Transistoren (620) basierend auf einer Größe des verstärkten HF-Signals an dem ersten HF-Ausgang zu erwärmen.

9. Einrichtung nach einem der Ansprüche 1 bis 7, wobei:
der HF-Verstärker (602) eine Vorverstärkungs(PPA)-Stufe, die einen ersten HF-Eingang aufweist, einen ersten Bias-Eingang und einen ersten HF-Ausgang umfasst;
der HF-Verstärker (602) eine Leistungsverstärkungs(PA)-Stufe, die einen zweiten HF-Eingang aufweist, der mit dem ersten HF-Ausgang gekoppelt ist, einen zweiten Bias-Eingang und einen zweiten HF-Ausgang umfasst;
der eine oder die mehreren Bias-Transistoren (610) konfiguriert sind, um ein erstes Bias-Signal an den ersten Bias-Eingang der Vorverstärkungsstufe (PPA-Stufe) bereitzustellen und ein zweites Bias-Signal an den zweiten Bias-Eingang der Leistungsverstärkungsstufe (PA-Stufe) bereitzustellen; und
die Steuerschaltung (630) konfiguriert ist, um das verstärkte HF-Signal an dem zweiten HF-Ausgang abzutasten, wobei der eine oder die mehreren Heiztransistoren (620) konfiguriert sind, um den einen oder die mehreren Bias-Transistoren (610) basierend auf einer Größe des verstärkten HF-Signals an dem zweiten HF-Ausgang zu erwärmen.

10. Einrichtung nach Anspruch 8 oder 9, wobei:
der eine oder die mehreren Bias-Transistoren (610) einen ersten Satz von einem oder mehreren Bias-Transistoren, die konfiguriert sind, um das erste Bias-Signal an die Vorverstärkungs(PPA)-Stufe bereitzustellen, und einen zweiten Satz von einem oder mehreren Bias-Transistoren, die konfiguriert sind, um das zweite Bias-Signal an die Leistungsverstärkungs(PA)-Stufe bereitzustellen, umfassen; und
der eine oder die mehreren Heiztransistoren (620) einen ersten Heiztransistor zwischen dem ersten Satz von einem oder mehreren Bias-Transistoren und dem zweiten Satz von einem oder mehreren Bias-Transistoren umfassen.

11. Einrichtung nach einem der Ansprüche 8 bis 10, wobei der eine oder die mehreren Heiztransistoren (620) ferner umfassen:
einen zweiten Heiztransistor auf einer ersten Seite des ersten Satzes von einem oder mehreren Bias-Transistoren, die einer zweiten Seite des ersten Satzes von einem oder mehreren Bias-Transistoren gegenüberliegt, angrenzend an den ersten Heiztransistor; und
einen dritten Heiztransistor auf einer ersten Seite des zweiten Satzes von einem oder mehreren Bias-Transistoren, die einer zweiten Seite des zweiten Satzes von einem oder mehreren Bias-Transistoren gegenüberliegt, angrenzend an den ersten Heiztransistor.

12. Verfahren (1200) zum Verstärken eines Hochfrequenzsignals, HF-Signals, wobei das Verfahren umfasst:
Betreiben (1202) eines HF-Verstärkers in einem Modus, in dem sich der HF-Verstärker als Reaktion auf ein Sendefreigabesignal ein- und ausschaltet;
Verstärken des HF-Signals durch den HF-Verstärker, wenn der HF-Verstärker eingeschaltet ist;
Bereitstellen (1204) eines temperaturabhängigen Bias-Signals von einem oder mehreren Bias-Transistoren an einen Bias-Eingang des HF-Verstärkers, wenn der HF-Verstärker eingeschaltet ist; und
Erwärmen (1206) des einen oder der mehreren Bias-Transistoren durch einen oder mehrere Heiztransistoren, während der HF-Verstärker eingeschaltet ist, um Temperaturunterschiede zwischen dem einen oder den mehreren Bias-Transistoren (610) und dem HF-Verstärker (602) auszugleichen.

13. Verfahren nach Anspruch 12, das ferner umfasst:
Erzeugen eines DC-Bias-Stroms, der dem Sendefreigabesignal folgt; und
Bereitstellen des DC-Bias-Stroms für den einen oder die mehreren Heiztransistoren, während der HF-Verstärker eingeschaltet ist.

14. Verfahren nach Anspruch 13, das ferner umfasst:
Zugreifen auf einen Parameter, auf dem eine Erwärmungsausgleichsmenge für den einen oder die mehreren Bias-Transistoren basiert; und
Erzeugen des DC-Bias-Stroms basierend auf dem Parameter, wobei eine Größe des DC-Bias-Stroms eine Wärmemenge steuert, die durch die Heiztransistoren erzeugt wird, um den einen oder die mehreren Bias-Transistoren zu erwärmen, während der HF-Verstärker eingeschaltet ist.

15. Verfahren nach Anspruch 12 oder 13, das ferner umfasst:
Bereitstellen einer Zielleistung des verstärkten HF-Signals an den HF-Verstärker; und
Bestimmen einer Größe des DC-Bias-Stroms basierend auf der Zielleistung des verstärkten HF-Signals.

## Revendications

1. Appareil permettant d'amplifier un signal de fréquence radio, RF, l'appareil comprenant :
un amplificateur RF (602) configuré pour recevoir une entrée de polarisation dépendant de la température et le signal RF, l'amplificateur RF (602) étant configuré pour amplifier le signal RF sur la base d'un signal d'autorisation de transmission (TX_EN) ;
un ou plusieurs transistors de polarisation (610) configurés pour générer le signal de polarisation dépendant de la température ; l'appareil étant **caractérisé en ce qu'**il comprend en outre :
un ou plusieurs transistors de chauffage (620) configurés pour chauffer le ou les transistors de polarisation (610) ; et
un circuit de commande (630) configuré pour amener le ou les transistors de chauffage (620) à chauffer le ou les transistors de polarisation (610) pendant que l'amplificateur RF (602) est sous tension pour compenser des différences de température entre le ou les transistors de polarisation (610) et l'amplificateur RF (602).

2. Appareil selon la revendication 1, dans lequel le circuit de commande (630) est configuré pour :
générer un courant de polarisation CC qui piste le signal d'autorisation de transmission ; et
fournir le courant de polarisation CC au ou aux transistors de chauffage (620) pour amener le ou les transistors de chauffage (620) à chauffer le ou les transistors de polarisation (610) pendant que l'amplificateur RF (602) est sous tension.

3. Appareil selon la revendication 2, dans lequel le circuit de commande (630) est configuré pour ;
fournir une compensation de chauffage au ou aux transistors de polarisation (610) sur la base d'un signal de commande reçu qui est généré par un processeur sur la base d'un paramètre spécifié ; et
générer le courant de polarisation CC sur la base du signal de commande, dans lequel une amplitude du courant de polarisation CC commande une quantité de chaleur générée par les transistors de chauffage (620) pour chauffer le ou les transistors de polarisation (610) pendant que l'amplificateur RF (602) est sous tension.

4. Appareil selon la revendication 2 ou 3, dans lequel le circuit de commande (630) est configuré pour :
déterminer une amplitude du courant de polarisation CC sur la base d'une puissance cible du signal RF amplifié délivré en sortie par l'amplificateur RF (602).

5. Appareil selon l'une quelconque des revendications 1 à 4, dans lequel :
le circuit de commande (630) est configuré pour échantillonner le signal RF amplifié à partir de l'amplificateur RF (602) et fournir le signal RF amplifié échantillonné au ou aux transistors de chauffage (620) ; et
le ou les transistors de chauffage (620) sont configurés pour chauffer le ou les transistors de polarisation (610) sur la base d'une amplitude du signal RF amplifié pendant que l'amplificateur RF (602) est sous tension.

6. Appareil selon l'une quelconque des revendications 2 à 5, dans lequel :
le ou les transistors de chauffage (620) comprennent un ou plusieurs transistors bipolaires à jonctions ;
le circuit de commande (630) fournit le courant de polarisation CC à une base de chacun du ou des transistors bipolaires à jonctions ; et
le circuit de commande (630) fournit le signal RF amplifié à la base de chacun du ou des transistors bipolaires à jonctions.

7. Appareil selon l'une quelconque des revendications 1 à 6, dans lequel le ou les transistors de chauffage (620) comprennent un premier transistor sur un premier côté du ou des transistors de polarisation et un deuxième transistor sur un second côté du ou des transistors de polarisation (610), dans lequel le second côté est opposé au premier côté.

8. Appareil selon l'une quelconque des revendications 1 à 7, dans lequel :
l'amplificateur RF (602) comprend un étage de préamplification (PPA) ayant une première entrée RF, l'entrée de polarisation qui est une première entrée de polarisation, et une première sortie RF ;
l'amplificateur RF (602) comprend un étage d'amplification de puissance (PA) ayant une seconde entrée RF couplée à la première sortie RF, une seconde entrée de polarisation et une seconde sortie RF ;
le ou les transistors de polarisation (610) sont configurés pour fournir un premier signal de polarisation à la première entrée de polarisation de l'étage de préamplification (PPA) et pour fournir un second signal de polarisation à la seconde entrée de polarisation de l'étage d'amplification de puissance (PA) ; et
le circuit de commande (630) est configuré pour échantillonner le signal RF amplifié au niveau de la première sortie RF, dans lequel le ou les transistors de chauffage (620) sont configurés pour chauffer le ou les transistors de polarisation (620) sur la base d'une amplitude du signal RF amplifié au niveau de la première sortie RF.

9. Appareil selon l'une quelconque des revendications 1 à 7, dans lequel :
l'amplificateur RF (602) comprend un étage de préamplification (PPA) ayant une première entrée RF, une première entrée de polarisation, et une première sortie RF ;
l'amplificateur RF (602) comprend un étage d'amplification de puissance (PA) ayant une seconde entrée RF couplée à la première sortie RF, une seconde entrée de polarisation et une seconde sortie RF ;
le ou les transistors de polarisation (610) sont configurés pour fournir un premier signal de polarisation à la première entrée de polarisation de l'étage de préamplification (PPA) et pour fournir un second signal de polarisation à la seconde entrée de polarisation de l'étage d'amplification de puissance (PA) ; et
le circuit de commande (630) est configuré pour échantillonner le signal RF amplifié au niveau de la seconde sortie RF, dans lequel le ou les transistors de chauffage (620) sont configurés pour chauffer le ou les transistors de polarisation (610) sur la base d'une amplitude du signal RF amplifié au niveau de la seconde sortie RF.

10. Appareil selon la revendication 8 ou 9, dans lequel :
le ou les transistors de polarisation (610) comprennent un premier ensemble d'un ou plusieurs transistors de polarisation configurés pour fournir le premier signal de polarisation à l'étage de préamplification (PPA) et un second ensemble d'un ou plusieurs transistors de polarisation configurés pour fournir le second signal de polarisation à l'étage d'amplification de puissance (PA) ; et
le ou les transistors de chauffage (620) comprennent un premier transistor de chauffage entre le premier ensemble d'un ou plusieurs transistors de polarisation et le second ensemble d'un ou plusieurs transistors de polarisation.

11. Appareil selon l'une quelconque des revendications 8 à 10, dans lequel le ou les transistors de chauffage (620) comprennent en outre :
un deuxième transistor de chauffage sur un premier côté du premier ensemble d'un ou plusieurs transistors de polarisation qui est opposé à un second côté du premier ensemble d'un ou plusieurs transistors de polarisation qui est adjacent au premier transistor de chauffage ; et
un troisième transistor de chauffage sur un premier côté du second ensemble d'un ou plusieurs transistors de polarisation qui est opposé à un second côté du second ensemble d'un ou plusieurs transistors de polarisation qui est adjacent au premier transistor de chauffage.

12. Procédé (1200) permettant d'amplifier un signal de fréquence radio, RF, le procédé comprenant :
le fonctionnement (1202) d'un amplificateur RF dans un mode dans lequel l'amplificateur RF est mis sous tension et hors tension en réponse à un signal d'autorisation de transmission ;
l'amplification du signal RF, par l'amplificateur RF, lorsque l'amplificateur RF est sous tension ;
la fourniture (1204) d'un signal de polarisation dépendant de la température provenant d'un ou plusieurs transistors de polarisation à une entrée de polarisation de l'amplificateur RF lorsque l'amplificateur RF est sous tension ; et
le chauffage (1206) du ou des transistors de polarisation, par un ou plusieurs transistors de chauffage, pendant que l'amplificateur RF est sous tension pour compenser des différences de température entre le ou les transistors de polarisation (610) et l'amplificateur RF (602).

13. Procédé selon la revendication 12, comprenant en outre :
la génération d'un courant de polarisation CC qui piste le signal d'autorisation de transmission ; et
la fourniture du courant de polarisation CC au ou aux transistors de chauffage pendant que l'amplificateur RF est sous tension.

14. Procédé selon la revendication 13, comprenant en outre :
l'accès à un paramètre sur lequel une quantité de compensation de chauffage pour le ou les transistors de polarisation est basée ; et
la génération du courant de polarisation CC sur la base du paramètre, dans lequel une amplitude du courant de polarisation CC commande une quantité de chaleur générée par les transistors de chauffage pour chauffer le ou les transistors de polarisation pendant que l'amplificateur RF est sous tension.

15. Procédé selon la revendication 12 ou 13, comprenant en outre :
la fourniture, à l'amplificateur RF, d'une puissance cible du signal RF amplifié ; et
la détermination d'une amplitude du courant de polarisation CC sur la base de la puissance cible du signal RF amplifié.
